# EUROPEAN PATENT APPLICATION

(11) **EP 4 654 807 A1**
(43) Date of publication of application: **26.11.2025**
(21) Application number: 25178556.4
(22) Date of filing: 23.05.2025
(51) Int. Cl.: H10K 85/60, H10K 85/10, H10K 50/15, H10K 50/17, H10K 50/19

(54) **LIGHT EMITTING ELEMENT, DISPLAY PANEL, AND ELECTRONIC DEVICE INCLUDING THE SAME**

(30) Priority: 24.05.2024 KR 20240067828
(71) Applicant: Samsung Display Co., Ltd., Gyeonggi-Do (KR)
(72) Inventor: KO, Hyomin, Yongin-si (KR); OH, Ilsoo, Yongin-si (KR)
(74) Representative: Marks & Clerk LLP

(57) **Abstract**

A light emitting element includes a first electrode, a hole injection layer on the first electrode, a first emission layer which is on the hole injection layer and emits light of a first wavelength, a first n-type charge generation layer on the first emission layer, a first p-type charge generation layer on the first n-type charge generation layer, a second emission layer which is on the first p-type charge generation layer and emits light of a second wavelength different from the first wavelength. An electron transport region is on the second emission layer. A display panel and an electronic device include the same.

## Description

### BACKGROUND

One or more aspects of embodiments of the present disclosure relate to a light emitting element and a display panel and an electronic device including the same. For example, the present disclosure pertains to a light emitting element designed (in which) to enhance the display efficiency and extend service life, as well as a display panel including the light emitting element.

Display devices, such as televisions, monitors, smartphones, and/or tablets, which provide images to users, include display panels for image presentation. Various display panels are being developed, including liquid crystal display panels, organic light-emitting display panels, electrowetting display panels, and electrophoretic display panels.

To improve reliability of the display panels, research has been conducted on methods for patterning light-emitting elements. Recently, studies have focused on high-resolution display devices that incorporate luminescent materials typically applied utilizing an open mask.

### SUMMARY

One or more aspects of embodiments of the present disclosure are directed toward a light emitting element with (having) improved display efficiency and display service life while achieving high resolution, and a display panel including the light emitting element. However, aspects of the present disclosure are not restricted to those set forth herein.

The preceding and other aspects of the present disclosure will become more apparent to one of ordinary skill in the art to which the present disclosure pertains by referencing the detailed description of the present disclosure.

One or more embodiments of the present disclosure provide a light emitting element including a first electrode, a hole injection layer arranged on the first electrode, a first emission layer which is arranged on the hole injection layer and emits (e.g., configured to emit) light of a first wavelength, a first n-type (kind) charge generation layer arranged on the first emission layer, a first p-type (kind) charge generation layer arranged on the first n-type (kind) charge generation layer, a second emission layer which is arranged on the first p-type (kind) charge generation layer and emits (e.g., configured to emit) light of a second wavelength that may be different from the first wavelength, an electron transport region arranged on the second emission layer, a second electrode arranged on the electron transport region, and a hole transport auxiliary layer which is arranged adjacent to at least one of the hole injection layer or the first p-type (kind) charge generation layer and includes a first amine compound and a first fluorine-containing compound, wherein the at least one layer (e.g., adjacent to the hole transport auxiliary layer) selected from among the hole injection layer and the first p-type (kind) charge generation layer includes a p-dopant, a second amine compound, and a second fluorine-containing compound.

In one or more embodiments, a weight ratio of the first amine compound and (e.g., to) the first fluorine-containing compound may be about 3:7 to about 5:5 in the hole transport auxiliary layer, and a weight ratio of the second amine compound and (e.g., to) the second fluorine-containing compound may be about 3:7 to about 5:5 in the at least one layer (e.g., including the second amine compound and the second fluorine-containing compound) selected from among the hole injection layer and the first p-type (kind) charge generation layer.

In one or more embodiments, the first fluorine-containing compound and the second fluorine-containing compound may each independently include at least one fluoropolymer, e.g., at least one of TEFLON (e.g., Teflon polymer or PTFE (polytetrafluoroethylene) polymer) or CYTOP (e.g., Cytop (cyclized transparent optical polymer) polymer).

In one or more embodiments, each of a water contact angle of each of the first fluorine-containing compound and the second fluorine-containing compound may independently be at least about 110° (e.g., or more).

In one or more embodiments, each of a lowest occupied molecular orbital (LUMO) level of each of the first fluorine-containing compound and the second fluorine-containing compound may independently be at most about 5.0 eV (e.g., or less).

In one or more embodiments, the hole transport auxiliary layer may include a plurality of first portions including the first amine compound and a plurality of second portions including the first fluorine-containing compound, and the plurality of first portions and the plurality of second portions may be arranged alternately in a direction normal (e.g., perpendicular) to a (e.g., the) thickness direction.

In one or more embodiments, the light emitting element may further include a hole transport layer arranged on the hole injection layer, wherein the hole transport auxiliary layer may be arranged between the hole injection layer and the hole transport layer.

In one or more embodiments, the hole transport auxiliary layer may be arranged to be spaced and/or apart (e.g., spaced apart or separated) from the first emission layer by a first distance with respect to a (e.g., the) thickness direction, and the first distance may be at least about 10 nanometers (nm) (e.g., or more).

In one or more embodiments, the hole transport auxiliary layer may be arranged directly on the hole injection layer, and the hole transport layer may be arranged directly on the hole transport auxiliary layer.

In one or more embodiments, the hole transport auxiliary layer may be arranged between the first p-type (kind) charge generation layer and the second emission layer.

In one or more embodiments, the hole transport auxiliary layer may be arranged to be spaced and/or apart (e.g., spaced apart or separated) from the second emission layer by a second distance with respect to the thickness direction, and the second distance may be at least about 10 nm (e.g., or more).

In one or more embodiments, the hole transport auxiliary layer may be arranged directly on the first p-type (kind) charge generation layer.

In one or more embodiments, the light emitting element may further include a middle hole transport layer which is arranged between the hole transport auxiliary layer and the second emission layer, and includes a hole transporting material.

In one or more embodiments, the light emitting element may further include a middle electron transport layer arranged between the first emission layer and the first n-type (kind) charge generation layer.

In one or more embodiments, the light emitting element may further include a second n-type (kind) charge generation layer arranged on the second emission layer, a second p-type (kind) charge generation layer arranged on the second n-type (kind) charge generation layer, and a third emission layer which is arranged on the second p-type (kind) charge generation layer and emits (e.g., configured to emit) light of a third wavelength that may be different from the first wavelength and the second wavelength.

In one or more embodiments, the light emitting element may further include a capping layer arranged on the second electrode, wherein the capping layer may have a refractive index of at least about 1.6 (e.g., or more).

In one or more embodiments of the present disclosure, a light emitting element includes a first electrode, a second electrode opposite to (e.g., facing) the first electrode, a plurality of light emitting stacks which are stacked to be arranged between the first electrode and the second electrode and each of which (e.g., the light emitting stacks) includes an emission layer and a plurality of functional layers, and a charge generation layer arranged between neighboring stacks among the plurality of light emitting stacks, wherein the charge generation layer includes an n-type (kind) charge generation layer including an n-dopant, and a p-type (kind) charge generation layer including a p-dopant, at least one functional layer of functional layers adjacent to the p-type (kind) charge generation layer and the p-type (kind) charge generation layer may (e.g., each) include an amine compound and a fluorine-containing compound.

In one or more embodiments, the at least one functional layer including the amine compound and the fluorine-containing compound may be arranged to be spaced and/or apart (e.g., spaced apart or separated) from the emission layer with respect to a (e.g., the) thickness direction, and the spaced distance between the at least one functional layer and the emission layer may be at least about 10 nm (e.g., or more).

In one or more embodiments of the present disclosure, an electronic device includes a base layer including a non-display region and a display region including a first light emitting region, a second light emitting region, and a non-light emitting region, a display element layer which is arranged on the base layer and includes a first light emitting element overlapping the first light emitting region and a second light emitting element overlapping the second light emitting region, wherein each of the first light emitting element and the second light emitting element includes a first electrode, a hole injection layer arranged on the first electrode, a first emission layer which is arranged on the hole injection layer and emits (e.g., configured to emit) light of a first wavelength, a first n-type (kind) charge generation layer arranged on the first emission layer, a first p-type (kind) charge generation layer arranged on the first n-type (kind) charge generation layer, a second emission layer which is arranged on the first p-type (kind) charge generation layer and emits (e.g., configured to emit) light of a second wavelength that may be different from the first wavelength, an electron transport region arranged on the second emission layer, a second electrode arranged on the electron transport region, and a hole transport auxiliary layer which is arranged adjacent to at least one of the hole injection layer or the first p-type (kind) charge generation layer and includes a first amine compound and a first fluorine-containing compound, wherein (e.g., the) at least one layer (e.g., adjacent to the hole transport auxiliary layer) selected from among the hole injection layer and the first p-type (kind) charge generation layer includes a p-dopant, a second amine compound, and a second fluorine-containing compound.

In one or more embodiments, the electronic device may further include an encapsulation layer arranged on the display element layer and a plurality of color filters which are arranged on the encapsulation layer and arranged in each of the first light emitting region and the second light emitting region.

At least some of the above and other features of the invention are set out in the claims.

### BRIEF DESCRIPTION OF THE DRAWINGS

The accompanying drawings are included to provide a further understanding of the preceding and other advantages of the present disclosure, and are incorporated in and constitute a part of this specification. The drawings illustrate example embodiments of the present disclosure and, together with the description, serve to explain principles of the present disclosure. In the drawings:
FIG. 1 is a perspective view illustrating an electronic device according to one or more embodiments of the present disclosure;
FIG. 2A is a perspective view illustrating the electronic device according to one or more embodiments of the present disclosure;
FIG. 2B is an exploded perspective view of the electronic device according to one or more embodiments of the present disclosure;
FIG. 3 is a plan view of a display panel according to one or more embodiments of the present disclosure;
FIG. 4 is a cross-sectional view of a display panel according to one or more embodiments of the present disclosure;
FIGS. 5A-5D are cross-sectional views of a light emitting element according to one or more embodiments of the present disclosure;
FIG. 5E is a cross-sectional view of a light emitting stack according to one or more embodiments of the present disclosure;
FIG. 6A is a cross-sectional view of a hole transport auxiliary layer included in a light emitting element of one or more embodiments of the present disclosure;
FIGS. 6B and 6C are each cross-sectional views illustrating some configuration of the light emitting elements of one or more embodiments of the present disclosure;
FIGS. 7A and 7B are graphs showing a current density depending on voltage in the light emitting elements of an Example and a Comparative Example; and
FIG. 7C is a graph showing changes in brightness over time in the light emitting elements of an Example and a Comparative Example.

### DETAILED DESCRIPTION

The present disclosure will now be described and may be embodied in many different forms and should thus not be construed as limited to one or more embodiments set forth herein. Rather, these embodiments are provided so that this disclosure will be thorough and complete, and will fully convey the scope of present disclosure to those skilled in the art.

Expressions such as "at least one of," "one of," "selected from," and "selected from among," when preceding a list of elements, modify the entire list of elements and do not modify the individual elements of the list. For example, throughout the disclosure, the expression "at least one of a, b or c" indicates only a, only b, only c, both (e.g., simultaneously) a and b, both (e.g., simultaneously) a and c, both (e.g., simultaneously) b and c, all of a, b, and c, or variations thereof.

In this specification, it will also be understood that if (e.g., when) a component (or a region, a layer, a portion, and/or the like) is referred to as being "on," "connected to," or "coupled to" another component, it may be directly connected/coupled to the other component, or an intervening third component may be also arranged therebetween.

Like reference numerals refer to like components, and duplicative descriptions thereof may not be provided. Also, in the drawings, the thicknesses, ratios, and dimensions of the components are exaggerated for effective description of technical contents. As used herein, the term "and/or" includes all combinations of one or more of which associated configurations may define.

It will be understood that, although the terms "first", "second", and/or the like may be used herein to describe one or more suitable components, these components should not be limited by these terms. These terms are only used to distinguish one component from another. For example, a first component could be termed a second component, and, similarly, a second component could be termed a first component, without departing from the scope of the present disclosure. The terms of a singular form such as "a", "an" and "the," may include plural forms unless the context clearly indicates otherwise.

Spatially relative terms such as "below," "on the lower portion of," "above," and "on the upper portion of" are used to describe the relationship of the configurations shown in the drawings. The terms are used as a relative concept and are described with reference to the direction indicated in the drawings.

It should be understood that terms "comprises," "comprising," "comprise," "includes," "including", "include," "have," "has," "having," and/or the like are intended to specify the presence of stated features, integers, steps, operations, components, parts, and/or one or more (e.g., any suitable) combinations thereof in the specification, but do not preclude the presence or addition of one or more other features, integers, steps, operations, components, parts, and/or one or more (e.g., any suitable) combinations thereof. Additionally, the terms "comprise(s)/comprising," "include(s)/including," "have/has/having", or other similar terms include or support the terms "consisting of" and "consisting essentially of," indicating the presence of stated features, integers, steps, operations, elements, and/or components, without or essentially without the presence of other features, integers, steps, operations, elements, components, and/or groups thereof.

Being "arranged directly on" herein refers to that there are no intervening layers, films, regions, plates, and/or the like between a part such as a layer, a film, a region, and a plate and another part. For example, being "arranged directly on" may refer to being arranged between two layers or two members without using an additional member, such as an adhesive member.

It will be understood that the spatially relative terms are intended to encompass different orientations of the device in use or operation in addition to the orientation depicted in the drawings. For example, if the device in the drawings is turned over, elements described as "below" or "beneath" other elements or features would then be oriented "above" or "over" the other elements or features. Thus, the term "below" may encompass both an orientation of above and below. The device may be otherwise oriented (rotated 90 degrees or at other orientations), and the spatially relative descriptors used herein should be interpreted accordingly.

Unless otherwise defined, all terms (including chemical, technical and scientific terms) used herein have the same meaning as commonly understood by one of ordinary skill in the art to which the present disclosure belongs. In some embodiments, it will be understood that terms, such as those defined in commonly used dictionaries, should be interpreted as having a meaning that is consistent with their meaning in the context of the relevant art and will not be interpreted in an idealized or overly formal sense unless expressly so defined herein.

The term "may" will be understood to refer to "one or more embodiments of the present disclosure," some of which include the described element and some of which exclude that element and/or include an alternate element. Similarly, alternative language such as "or" refers to "one or more embodiments of the present disclosure," each including a corresponding listed item.

In this context, "consisting essentially of" indicates that any additional components will not materially affect the chemical, physical, optical or electrical properties of the semiconductor film.

Hereinafter, an electronic device and a display panel included therein according to one or more embodiments of the present disclosure will be described with reference to the drawings in which one or more embodiments of present disclosure are shown. An aspect and a characteristic of the disclosure, and a method of accomplishing these will be apparent referring to one or more embodiments described with reference to the drawings. In this specification, phrases such as "on a plane," "plan view," and/or the like indicate viewing a target portion from the top, and the phrase "on a cross-section" indicates viewing a cross-section formed by vertically cutting a target portion from the side.

### Electronic device

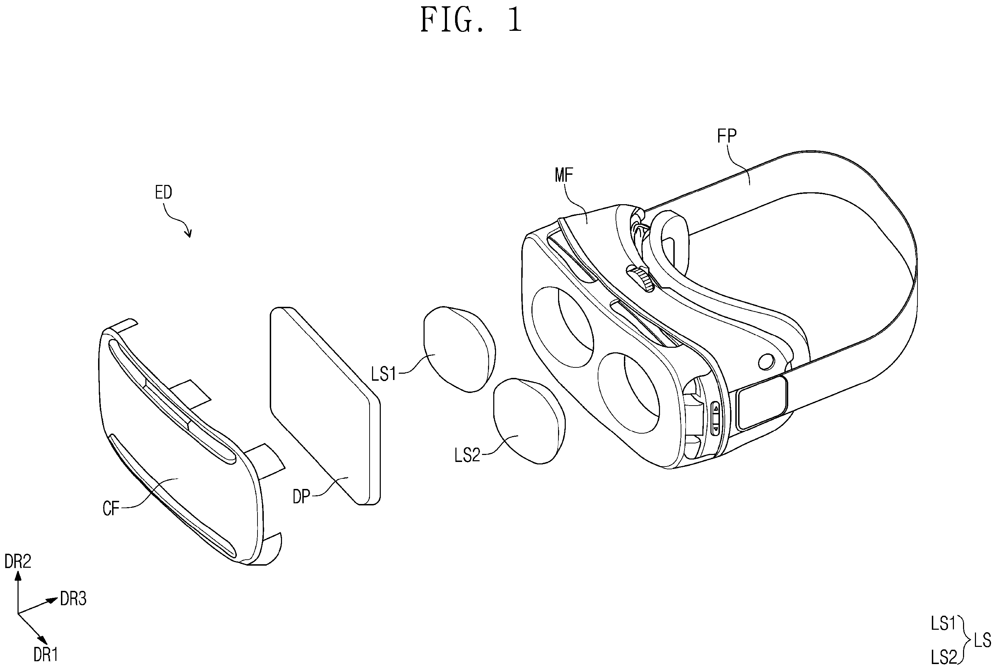

FIG. 1 is a perspective view illustrating an electronic device EE according to one or more embodiments of the present disclosure. The electronic device EE may be a device that is activated according to an electrical signal. For example, the electronic device EE may be a television, a monitor, an external billboard, a game console, a personal computer, a laptop computer, a mobile phone, a tablet, a game console, a navigation device, and a wearable device, but one or more embodiments of the present disclosure is not limited thereto.

FIG. 1 illustrates a head mounted display (HMD) device as an example of the electronic device EE. The head mounted display device may be a device mounted on the user's head to provide a screen on which a video or an image is displayed to the user. The head mounted display device may include a see-through type (kind) that provides augmented reality (AR) based on real external objects and a see-closed type (kind) that provides virtual reality (VR) to a user on a screen independent of the external aspect.

Referring to FIG. 1, the electronic device EE may include a display panel DP and a lens part LS that faces the display panel DP. In some embodiments, the electronic device EE may include a main frame MF, a cover frame CF, and a fixing portion FP.

The main frame MF may be a portion worn on the user's face. The main frame MF may have a shape corresponding to the shape of the head (face) of the user. For example, the length of the fixing portion FP may be adjusted according to the circumference of the user's head. The fixing portion FP is a structure that facilitates mounting of the main frame MF, and may include a strap, a band, and/or the like. However, one or more embodiments of the present disclosure is not limited thereto, and the fixing portion FP may have one or more suitable shapes such as a helmet or eyeglass legs coupled to the main frame MF.

The lens part LS, the display panel DP, and the cover frame CF may be mounted on the main frame MF. The main frame MF may include a space or a structure in which the lens part LS and the display panel DP may be accommodated.

The lens part LS may be arranged between the display panel DP the user. The lens part LS may be to transmit light emitted from the display panel DP to provide the light to the user. For example, the lens part LS may include one or more suitable types (kinds) of lenses such as a multi-channel lens, a convex lens, a concave lens, a spherical lens, an aspherical lens, a single lens, a compound lens, a standard lens, a narrow-angle lens, a wide-angle lens, a fixed focal lens, and a varifocal lens.

The lens part LS may include a first lens LS1 and a second lens LS2. The first lens LS1 and the second lens LS2 may be arranged to correspond to positions of the right eye and the left eye of the user, respectively. The first lens LS1 and the second lens LS2 may be accommodated in the main frame MF.

The display panel DP may be provided in a state of being fixed to the main frame MF, or may be provided in a detachable state. The display panel DP will be described in more detail later in more detail.

The cover frame CF may be arranged on one surface of the display panel DP to protect the display panel DP. The cover frame CF and the lens part LS may be spaced and/or apart (e.g., spaced apart or separated) from each other with the display panel DP interposed therebetween.

FIG. 1 and the following drawings illustrate the first direction DR1 to third direction DR3, and the directions indicated by the first to third directions DR1, DR2 and DR3 described in this specification are relative concepts and may be converted into other directions. In some embodiments, the directions indicated by the first to third directions DR1, DR2 and DR3 may be described as first to third directions, and the same reference symbols may be used. In the present specification, the first direction DR1 and the second direction DR2 are orthogonal to each other, and the third direction DR3 may be a normal line direction with respect to a plane defined by the first direction DR1 and the second direction DR2.

The electronic device EE may have a thickness direction parallel to the third direction DR3 that is the normal direction with respect to the plane defined by the first direction DR1 and the second direction DR2. In this specification, a front surface (or top surface) and a rear surface (or bottom surface) of members of the electronic device EE may be defined on the basis of the third direction DR3. In this specification, "on a plane" refers to a plane parallel to a plane defined by the first direction DR1 and the second direction DR2, and "on a cross-section" refers to a plane parallel to the third direction DR3.

In the present context and unless defined otherwise, a plan view refers to a view from above, showing the layout of the device as if looking down on it along the third direction DR3. The plan view is parallel to the plane defined by the first direction DR1 and the second direction DR2. It is a horizontal cut through the structure, typically just above the floor, and shows the arrangement of components from a top-down perspective.

In the present context and unless defined otherwise, a cross-section view refers to a vertical cut through the device, revealing internal features and details not visible from the outside. The cross-section view is parallel to the third direction DR3, which is the normal direction with respect to the plane defined by DR1 and DR2. It is like slicing through the object to see its interior components, such as walls, floors, and structural elements.

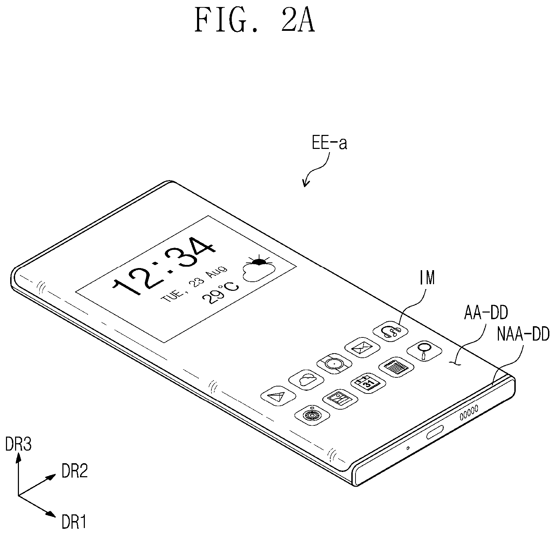

FIG. 2A is a perspective view illustrating an electronic device EE-a according to one or more embodiments of the present disclosure. FIG. 2A is a perspective view illustrating one or more embodiments of the electronic device of the present disclosure, and illustrates a mobile phone as an example of the electronic device EE-a. The electronic device EE-a may display an image IM through an active region AA-DD. The active region AA-DD may include a plane defined by the first direction DR1 and the second direction DR2. The active region AA-DD may include a curved surface bent from at least one side of the plane defined by the first direction DR1 and the second direction DR2. However, this is an example, and the shape of the active region AA-DD is not limited thereto. For example, the active region AA-DD may include only the plane, and the active region AA-DD may further include four curved surfaces respectively bent from at least two or more, for example, four sides of the plane.

The peripheral region NAA-DD is adjacent to the active region AA-DD. The peripheral region NAA-DD may be around (e.g., surround) the active region AA-DD. Accordingly, the shape of the active region AA-DD may be substantially defined by the peripheral region NAA-DD. However, this is illustrated by way of example, and the peripheral region NAA-DD may be arranged adjacent to only one side of the active region AA-DD, or may not be provided. The active region AA-DD may be provided in one or more suitable shapes, and is not limited to any one or more embodiments.

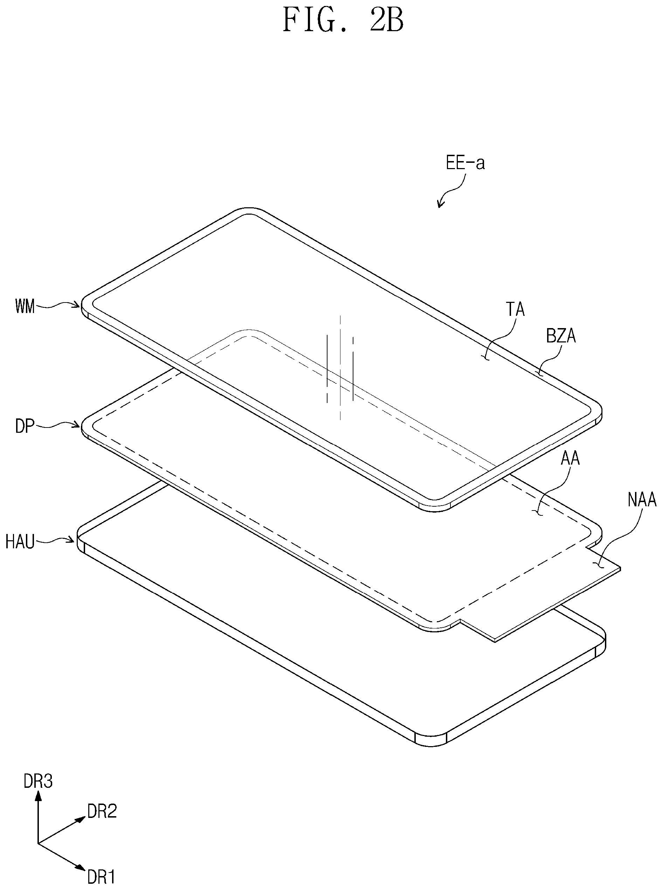

FIG. 2B is an exploded perspective view of the electronic device EE-a illustrated in FIG. 2A. Referring to FIG. 2B, the electronic device EE-a may include a housing HAU, a display panel DP, and a window member WM.

The window member WM may cover the entire outside of the display panel DP. The window member WM may include a transmission region TA and a bezel region BZA. The front surface of the window member WM including the transmission region TA and the bezel region BZA may correspond to the front surface of the electronic device EE-a. The transmission region TA may correspond to the active region AA-DD of the electronic device EE-a illustrated in FIG. 2A, and the bezel region BZA may correspond to the peripheral region NAA-DD of the electronic device EE-a illustrated in FIG. 2A.

The transmission region TA may be an optically clear region. The bezel region BZA may have a light transmittance relatively lower than the transmission region TA. The bezel region BZA may have a certain color. The bezel region BZA may be adjacent to the transmission region TA, and may be around (e.g., surround) the transmission region TA. The bezel region BZA may define the shape of the transmission region TA. However, one or more embodiments of the present disclosure is not limited to the one illustrated, the bezel region BZA may be arranged adjacent to only one side of the transmission region TA, and a part thereof may not be provided.

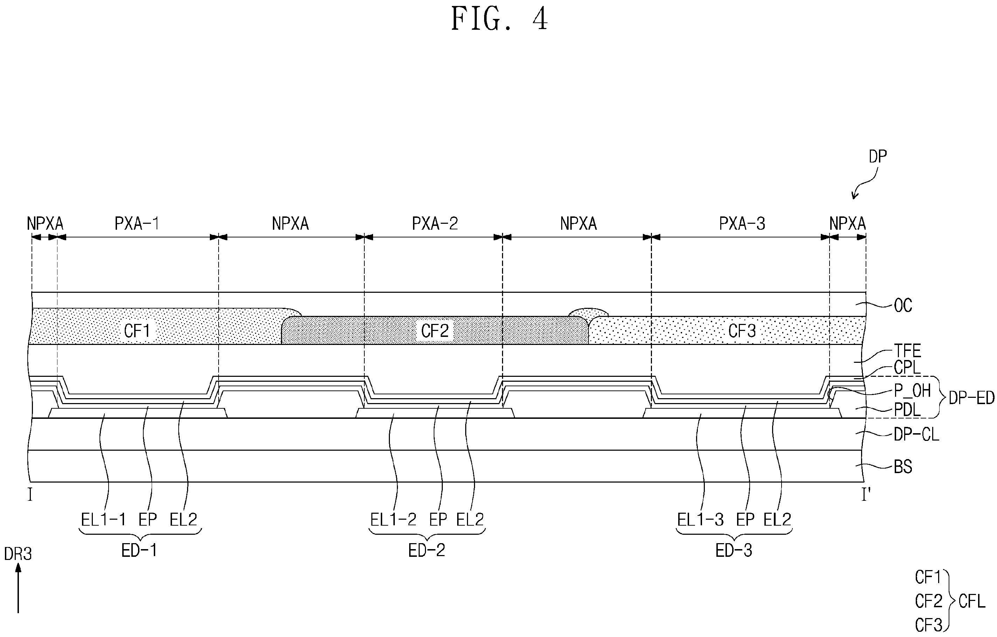

In one or more embodiments, an input sensing unit may be provided on the display panel DP. The input sensing unit may sense an external input applied from the outside. The external input may be a user's input. The user's input may include one or more suitable types (kinds) of external inputs such as a part of a user's body, light, heat, pen, or pressure. For example, the input sensing unit may be arranged on an encapsulation layer TFE (see FIG. 4) of the display panel DP which will be described in more detail later. In one or more embodiments, the input sensing unit may be arranged directly on the encapsulation layer TFE (see FIG. 4), or may be arranged directly on an adhesive member arranged on the encapsulation layer TFE (see FIG. 4). The adhesive member may include a typical adhesive or pressure adhesive.

In this specification, if (e.g., when) one component (or region, layer, part, and/or the like) is referred to as "arranged directly" on the other component, it refers to that a third component is not arranged between one component and the other component. For example, that one component is "arranged directly" on the other component refers to that one component is in "contact" with the other component.

The housing HAU may accommodate the display panel DP, and/or the like. The housing HAU may be coupled to the window member WM.

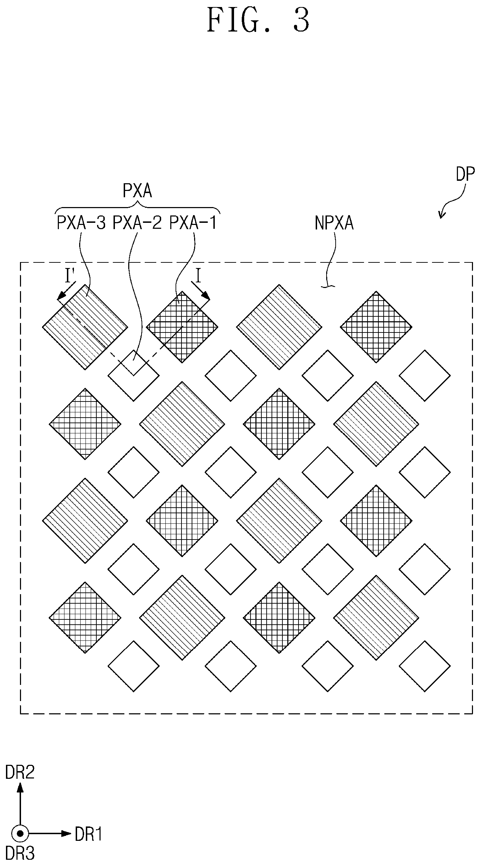

FIG. 3 is a plan view illustrating a display panel DP according to one or more embodiments. Hereinafter, the description of the display panel DP may be equally applied to the display panel DP included in each of the electronic devices ED and EE-a illustrated in FIGS. 1 and 2A.

Referring to FIG. 3, the display panel DP may include a light emitting region PXA and a non-light emitting region NPXA. The non-light emitting region NPXA may be around (e.g., surround) the light emitting region PXA. A plurality of light emitting regions PXA may be provided. The light emitting regions PXA may include first light emitting regions PXA-1, second light emitting regions PXA-2, and third light emitting regions PXA-3. The first light emitting regions PXA-1, the second light emitting regions PXA-2, and the third light emitting regions PXA-3 may each emit light in different wavelength regions. The first light emitting regions PXA-1 may be to emit first light, and the second light emitting regions PXA-2 may be to emit second light different from the first light. The third light emitting regions PXA-3 may be to emit third light different from the first light and the second light. In one or more embodiments, the first light may be red light, the second light may be green light, and the third light may be blue light.

Among the first to third light emitting regions PXA-1, PXA-2, and PXA-3, the area of the third light emitting regions PXA-3 may be the largest, and the area of the second light emitting regions PXA-2 may be the smallest. However, this is merely an example, and the areas of the first to third light emitting regions PXA-1, PXA-2, and PXA-3 are not limited thereto. In FIG. 3, it is illustrated that the first light emitting regions PXA-1 and the third light emitting regions PXA-3 are alternately arranged in one row, and the second light emitting regions PXA-2 are spaced and/or apart (e.g., spaced apart or separated) from the first light emitting regions PXA-1 and the third light emitting regions PXA-3 and are arranged in another row. However, this is merely an example, and the arrangement of the first to third light emitting regions PXA-1, PXA-2, and PXA-3 is not limited thereto.

FIG. 4 is a cross-sectional view of a display panel according to one or more embodiments of the present disclosure. FIG. 4 is a cross-sectional view illustrating a part taken along the line I-I' of FIG. 3.

Referring to FIG. 4, the display panel DP may include a base layer BS, a circuit layer DP-CL arranged on the base layer BS, a display element layer DP-ED arranged on the circuit layer DP-CL, and an encapsulation layer TFE arranged on the display element layer DP-ED. In some embodiments, the display panel DP may further include a color filter layer CFL arranged on the encapsulation layer TFE and an outer coating layer OC arranged on the color filter layer CFL..

Referring to FIG. 4, the base layer BS may be a member providing a base surface on which the circuit layer DP-CL is arranged. The base layer BS may be a rigid substrate or a flexible substrate that is bendable, foldable, rollable, and/or the like. The base layer BS may be a glass substrate, a metal substrate, or a polymer substrate. However, one or more embodiments of the present disclosure is not limited thereto, and the base layer BS may be an inorganic layer, an organic layer, or a composite material layer.

The base layer BS may include a single-layered structure or a multi-layered structure. For example, the base layer BS may include a first synthetic resin layer, a middle layer in a multi-layered or a single-layered structure, and a second synthetic resin layer, which are sequentially stacked. The middle layer may be referred to as a base barrier layer. The middle layer may include a silicon oxide (SiOₓ, e.g., 0 < x ≤ 2) layer, and an amorphous silicon (a-Si) layer arranged on the silicon oxide layer, but is not particularly limited thereto. For example, the middle layer may include at least one of a silicon oxide layer, a silicon nitride layer, a silicon oxynitride layer, or an amorphous silicon layer.

Each of the first and second synthetic resin layers may include a polyimide-based resin. Also, each of the first and second synthetic resin layers may include at least one of an acrylate-based resin, a methacrylate-based resin, a polyisoprene-based resin, a vinyl-based resin, an epoxy-based resin, a urethane-based resin, a cellulose-based resin, a siloxane-based resin, a polyamide-based resin, or a perylene-based resin. In this specification, "a"-based resin refers to including a functional group of "a."

The circuit layer DP-CL may be arranged on the base layer BS. The circuit layer DP-CL may include an insulation layer, a semiconductor pattern, a conductive pattern, a signal line, and/or the like. The insulating layer, the semiconductor layer, and the conductive layer are formed on the base layer BS through methods such as coating or vapor deposition, and then the insulating layer, the semiconductor layer, and the conductive layer may be selectively patterned through plural times of a photolithography process. Thereafter, the semiconductor pattern, the conductive pattern, and the signal line, which are contained in the circuit layer DP-CL, may be formed.

In one or more embodiments, the base layer BS may be a silicon substrate. The base layer BS may be a monocrystalline silicon wafer, a polycrystalline silicon wafer, or an amorphous silicon wafer. The circuit layer DP-CL may include an insulation layer, a semiconductor pattern, a conductive pattern, a signal line, and/or the like formed on a silicon wafer.

The display element layer DP-ED may be arranged on the circuit layer DP-CL. The display element layer DP-ED may include first to third light emitting elements ED-1, ED-2, and ED-3 and a pixel defining film PDL. Referring to FIG. 4, the first to third light emitting elements ED-1, ED-2, and ED-3 may be spaced and/or apart (e.g., spaced apart or separated) from each other in a direction normal (e.g., perpendicular) to the thickness direction DR3.

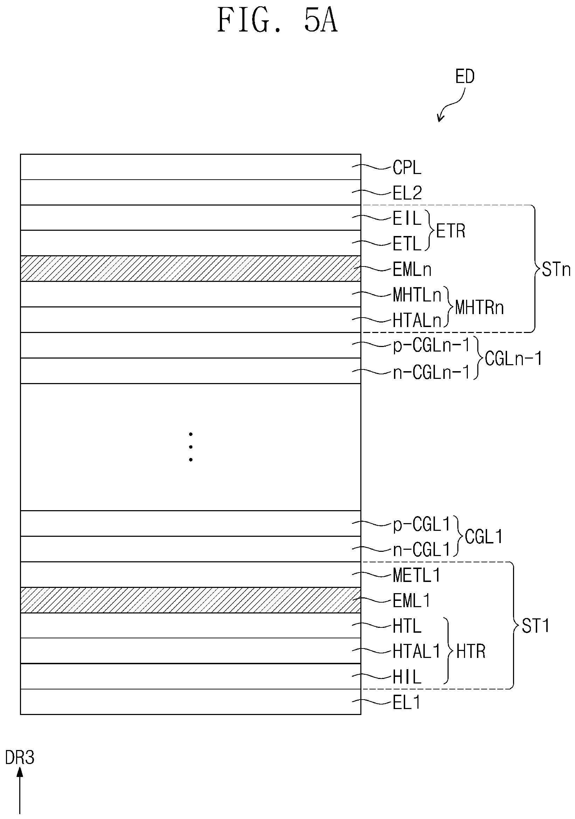

The first to third light emitting elements ED-1, ED-2, and ED-3 may be light emitting elements having a tandem structure. The first to third light emitting elements ED-1, ED-2, and ED-3 may respectively include first electrodes EL1-1, EL1-2, and EL1-3, a light emitting part EP arranged on the first electrodes EL1-1, EL1-2, and EL1-3, and a second electrode EL2 arranged on the light emitting part EP. In some embodiments, each of the first to third light emitting elements ED-1, ED-2, and ED-3 may further include a capping layer CPL. The light emitting part EP may include at least a plurality of emission layers EML1, EML2, ..., and EMLn (see FIGS. 5A to 5D). The light emitting part EP will be described later in more detail.

In the first to third light emitting elements ED-1, ED-2, and ED-3, the light emitting part EP may be provided as a common layer. The light emitting part EP may overlap the first to third light emitting regions PXA-1, PXA-2, and PXA-3 and the non-light emitting region NPXA. In the present specification, overlapping of one component and the other component is not limited to the same area and the same shape on a plane, and also includes cases having different areas and/or different shapes.

In the first to third light emitting elements ED-1, ED-2, and ED-3, the second electrode EL2 may be provided as a common electrode. The second electrode EL2 may be a common layer overlapping all of the first to third light emitting regions PXA-1, PXA-2, and PXA-3 and the non-light emitting region NPXA and having an integral shape.

The display element layer DP-ED of the display panel DP may include the pixel defining film PDL. The pixel defining film PDL may be arranged on at least a portion of the first electrodes EL1-1, EL1-2, and EL1-3. The pixel defining film PDL may cover a portion of an edge of each of the first electrodes EL1-1, EL1-2, and EL1-3. The pixel defining film PDL may include a pixel opening P_OH exposing at least a portion of the upper surfaces of the first electrodes EL1-1, EL1-2, and EL1-3. The pixel opening P_OH may define the first to third light emitting regions PXA-1, PXA-2, and PXA-3. The non-light emitting region NPXA may be a region corresponding to the pixel defining film PDL.

The pixel defining film PDL may include an inorganic material. The pixel defining film PDL may include at least one of silicon oxide (SiOₓ), silicon nitride (SiN_{y}), or silicon oxynitride (SiOₓN_{y}), e.g., 0 < x ≤ 2 and 0 < y ≤ 2. The pixel defining film PDL may include, for example, silicon oxide (SiOₓ).

The capping layer CPL may be arranged on the second electrode EL2. The capping layer CPL may include a multilayer or a single layer. The capping layer CPL may be an organic layer or an inorganic layer. For example, if (e.g., when) the capping layer CPL contains an inorganic material, the inorganic material may include an alkaline metal compound (e.g., LiF), an alkaline earth metal compound (e.g., MgF₂), SiON, SiNₓ, SiOy, and/or the like. Unlike this, the, if (e.g., when) the capping layer CPL includes an organic material, the organic material may include α-NPD, NPB, TPD, m-MTDATA, Alq₃, CuPc, N4,N4,N4',N4'-tetra(biphenyl-4-yl)biphenyl-4,4'-diamine (TPD15), 4,4',4"-tris(carbazol-9-yl)triphenylamine (TCTA), and/or the like, or an epoxy resin, and/or acrylate such as methacrylate.

In one or more embodiments, the refractive index of the capping layer CPL may be at least about 1.6 (e.g., or more). For example, the refractive index of the capping layer CPL may be at least about 1.6 (e.g., or more) with respect to light in a wavelength range of about 550 nanometer (nm) to about 660 nm.

The encapsulation layer TFE may be arranged on the display element layer DP-ED. The encapsulation layer TFE may protect the display element layer DP-ED from foreign substances such as moisture, oxygen, and/or the dust particles. The encapsulation layer TFE may include at least one inorganic film (hereinafter, an encapsulation-inorganic film). The encapsulation layer TFE may also include at least one organic film (hereinafter, an encapsulation-organic film) and at least one encapsulation-inorganic film.

The encapsulation-inorganic film may protect the display element layer DP-ED from moisture and/or oxygen, and the encapsulation-organic film may protect the display element layer DP-ED from foreign substances such as dust particles. The encapsulation-inorganic film may include silicon nitride, silicon oxynitride, silicon oxide, titanium oxide, aluminium oxide, and/or the like, but one or more embodiments of the present disclosure is not particularly limited thereto. The encapsulation-organic film may include an acrylic-based compound, an epoxy-based compound, and/or the like. The encapsulation-organic film may include a photopolymerizable organic material, but one or more embodiments of the present disclosure is not particularly limited thereto.

The color filter layer CFL may be arranged on the encapsulation layer TFE. The color filter layer CFL may include a first filter CF1 corresponding to the first light emitting region PXA-1, a second filter CF2 corresponding to the second light emitting region PXA-2, and a third filter CF3 corresponding to the third light emitting region PXA-3. The color filter layer CFL may further include a light shielding part. The light shielding part may be a black matrix. The light shielding part may include an organic light shielding material or an inorganic light shielding material containing a black pigment or dye. The light shielding part may prevent or reduce light leakage, and may separate boundaries between the adjacent filters CF1, CF2, and CF3.

Each of the first to third filters CF1, CF2, and CF3 may include a polymeric photosensitive resin and a colorant. In the present specification, the colorant includes a pigment and a dye. A red colorant includes a red pigment and a red dye, a green colorant includes a green pigment and a green dye, and a blue colorant includes a blue pigment and a blue dye.

In FIG. 4, the first filter CF1 may include a red pigment or a red dye, the second filter CF2 may include a green pigment or a green dye, and the third filter CF3 may include a blue pigment or a blue dye. For example, the first filter CF1 arranged on the first light emitting element ED-1 may include the red colorant, the second filter CF2 arranged on the second light emitting element ED-2 may include the green colorant, and the third filter CF3 arranged on the third light emitting element ED-3 may include the blue colorant.

FIGS. 5A to 5D are cross-sectional views of a light emitting element according to one or more embodiments of the present disclosure. FIGS. 5A to 5D each illustrate a structure of one light emitting element representing light emitting elements included in the display panel of the embodiment. The description of the light emitting element ED to be described with reference to FIGS. 5A to 5D may be equally applied to each of the first to third light emitting elements ED-1, ED-2, and ED-3 of FIG. 4.

Referring to FIG. 5A, the light emitting element ED may include a first electrode EL1, a second electrode EL2, and a plurality of stacks ST1, ..., and STn arranged between the first electrode EL1 and the second electrode EL2. The plurality of stacks ST1, ..., and STn may include n stacks ST1, ..., and STn. Here, n may be an integer of 2 or more. For example, the light emitting element ED may include at least two stacks. For example, the light emitting element ED may include two stacks, three stacks, or four or more stacks. The plurality of light emitting stacks ST1, ..., and STn may be sequentially stacked and arranged between the first electrode EL1 and the second electrode EL2.

Each of the plurality of light emitting stacks ST1, ..., and STn may include emission layers EML1, ..., and EMLn and a plurality of functional layers HIL, HTAL1, HTL, METL1, HTALn, MHTLn, ETL, and EIL. In the present specification, the term "functional layer" may refer to the remaining layer except for the emission layer in the light emitting stack. Each of the plurality of light emitting stacks ST1, ..., and STn may include lower functional layers HIL, HTAL1, HTL, HTALn, and MHTLn, emission layers EML1, ..., and EMLn, and upper functional layers METL1, ETL, and EIL, which are sequentially stacked. Here, the lower functional layer may be a hole transporting functional layer that functions as hole injection or hole transport, and the upper functional layer may be an electron transporting functional layer that functions as electron injection or electron transport. However, one or more embodiments of the present disclosure is not limited thereto.

In one or more embodiments, in FIG. 5A, "n" after the reference numerals of the hole transport auxiliary layer HTAL, the middle hole transport layer MHTL, and the middle hole transport region MHTR refers to a number of stacks in which each layer is included. For example, in FIG. 5A, "HTALn" may refer to a hole transport auxiliary layer included in the n-th stack, and "MHTLn" may refer to a middle hole transport layer included in the n-th stack.

In the light emitting element ED of one or more embodiments, the charge generation layers CGL1, ..., and CGLn-1 may be arranged between neighboring stacks among the plurality of stacks ST1, ..., and STn. The charge generation layers CGL1, ..., and CGLn-1 may be arranged between sequential pairs of the light emitting stacks ST1, ..., and STn, respectively. In one or more embodiments, the light emitting element ED may include n stacks ST1, ..., and STn and n-1 charge generation layers CGL1, ..., and CGLn-1.

The charge generation layers CGL1, ..., and CGLn-1 may include p-type (kind) charge generation layers p-CGL, ..., and p-CGLn-1 and/or n-type (kind) charge generation layers n-CGL, ..., and n-CGLn-1. The charge generation layers CGL1, ..., and CGLn-1 may facilitate the movement of holes and/or charges.

The charge generation layers CGL1, ..., and CGLn-1 may have a layered structure in which the n-type (kind) charge generation layers n-CGL1, ..., and n-CGLn-1 and the p-type (kind) charge generation layers p-CGL1, ..., and p-CGLn-1 are joined together. For example, as illustrated in FIG. 5A, a first charge generation layer CGL1 may have a layered structure in which a first n-type (kind) charge generation layer n-CGL1 and a first p-type (kind) charge generation layer p-CGL1 are joined together.

The n-type (kind) charge generation layers n-CGL1, ..., and n-CGLn-1 may be charge generation layers that provide electrons to adjacent stacks. The n-type (kind) charge generation layers n-CGL1, ..., and n-CGLn-1 may include n-dopants. The n-type (kind) charge generation layers n-CGL1, ..., and n-CGLn-1 may be layers in which a base material is doped with a n-dopant. The p-type (kind) charge generation layers p-CGL1, ..., and p-CGLn-1 may be charge generation layers that provide holes to adjacent stacks. The p-type (kind) charge generation layers p-CGL1, ..., and p-CGLn-1 may include p-dopants. The p-type (kind) charge generation layers p-CGL1, ..., and p-CGLn-1 may be layers in which a base material is doped with a p-dopant. In one or more embodiments, buffer layers may further be arranged between sequential pairs of the n-type (kind) charge generation layers n-CGL1, ..., and n-CGLn-1 and the p-type (kind) charge generation layers p-CGL1, ..., and p-CGLn-1, respectively.

The charge generation layers CGL1, ..., and CGLn-1 may generate charges (electrons and holes) by forming a complex through an oxidation-reduction reaction if (e.g., when) a voltage is applied thereto. In some embodiments, the charge generation layers CGL1, ..., and CGLn-1 may provide the generated charges to each of adjacent light emitting stacks ST1, ..., and STn. The charge generation layers CGL1, ..., and CGLn-1 may double the efficiency of currents generated in each of the adjacent light emitting stacks ST1, ..., and STn, and may serve to adjust the balance of charges between the adjacent light emitting stacks ST1 and STn.

The charge generation layers CGL1, ..., and CGLn-1 may include n-type (kind) aryl amine-based materials or p-type (kind) metal oxides. For example, the charge generation layers CGL1, ..., and CGLn-1 may include a charge generation compound consisting of an aryl amine-based organic compound, a metal, an oxide, a carbide, and a fluoride of the metal, and/or a (e.g., any suitable) mixture thereof.

For example, the aryl amine-based organic compound may include α-NPD, 2-TNATA, TDATA, MTDATA, sprio-TAD, or sprio-NPB. For example, the metal may be cesium (Cs), molybdenum (Mo), vanadium (V), titanium (Ti), tungsten (W), barium (Ba), or lithium (Li). Also, for example, the oxide, carbide, and fluoride of the metal may be Re₂O₇, MoO₃, V₂O₅, WO₃, TiO₂, Cs₂CO₃, BaF, LiF, or CsF.

In one or more embodiments, the p-type (kind) charge generation layers p-CGL, ..., and p-CGLn-1 may include organic dopants. The organic dopant may be, for example, a p-type (kind) dopant. For example, the p-type (kind) dopant may include at least one of 4-[[2,3-bis[cyano-(4-cyano-2,3,5,6-tetrafluorophenyl)methylidene]cyclopropylidene]-cyanomethyl]-2,3,5,6-tetrafluorobenzonitrile (hereinafter, NDP9), 1,4,5,8,9,11-hexaazatriphenylene-hexacarbonitrile (HAT-CN), 2,3,5,6-tetrafluoro-7,7,8,8-tetracyanoquinodimethane (F4-TCNQ), or tetracyanoquinodimethane (TCNQ). The organic dopant included in the p-type (kind) charge generation layers p-CGL, ..., and p-CGLn-1 may include an organic material having a highest occupied molecular orbital (HOMO) level of about -6.0 eV to about -4.0 eV. In one or more embodiments, the doping concentration of the organic dopant included in the p-type (kind) charge generation layers p-CGL, ..., and p-CGLn-1 may be about 0.5% to about 30%.

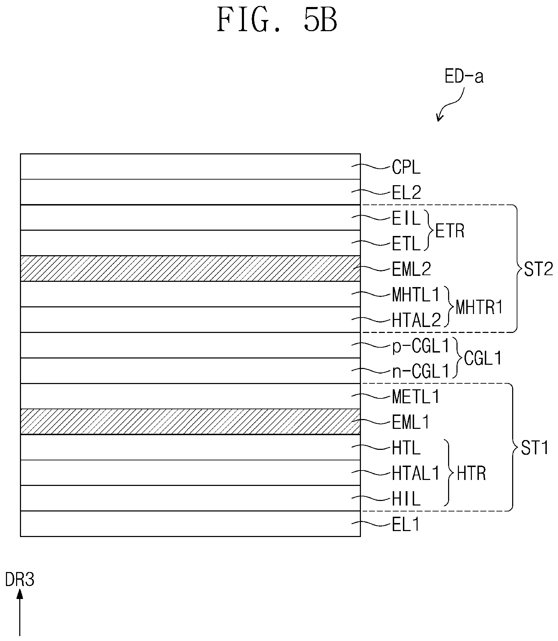

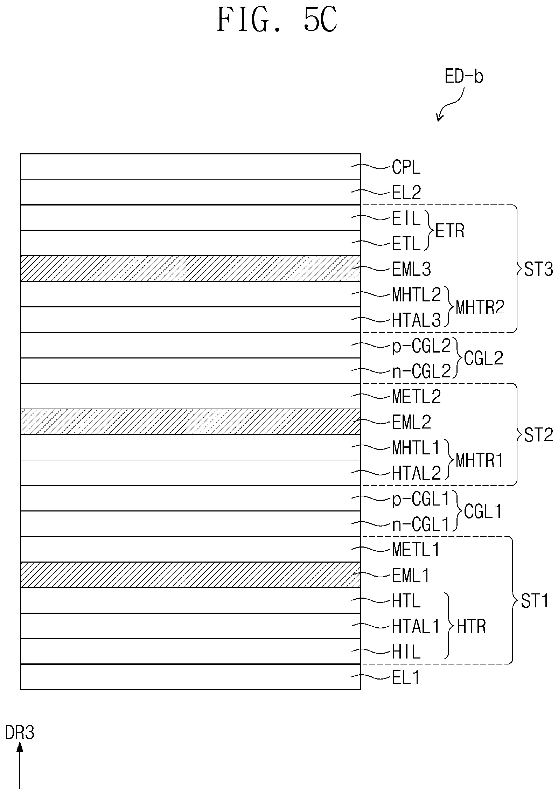

Hereinafter, with reference to FIGS. 5B and 5C, light emitting elements ED-a and ED-b respectively including two stacks and three stacks of an example will be described in more detail. FIG. 5B illustrates one or more embodiments of the light emitting element ED-a including two light emitting stacks stacked between a first electrode EL1 and a second electrode EL2. FIG. 5C illustrates one or more embodiments of the light emitting element ED-b including three light emitting stacks stacked between a first electrode EL1 and a second electrode EL2.

Referring to FIG. 5B, the light emitting element ED-a of one or more embodiments includes the first electrode EL1, the second electrode EL2 opposite to (e.g., facing) the first electrode EL1, and the plurality of light emitting stacks ST1 and ST2 arranged between the first electrode EL1 and the second electrode EL2. The plurality of light emitting stacks ST1 and ST2 may include a first light emitting stack ST1 and a second light emitting stack ST2. Each of the first light emitting stack ST1 and the second light emitting stack ST2 may include an emission layer.

In the light emitting element ED-a of one or more embodiments, a hole transport region HTR may be arranged between the first electrode EL1 and a first emission layer EML1. An electron transport region ETR may be arranged between the second electrode EL2 and a second emission layer EML2. In one or more embodiments, the light emitting element ED-a may be to emit light from the first electrode EL1 toward the second electrode EL2. In the light emitting element ED-a of one or more embodiments, a structure in which the hole transport region HTR is arranged under the plurality of light emitting stacks ST1 and ST2 and the electron transport region ETR is arranged on the upper portion of the plurality of light emitting stacks ST1 and ST2 is exemplarily illustrated with respect to the direction in which the light is emitted. However, one or more embodiments of the present disclosure is not limited thereto, and the light emitting element may have an inverted element structure in which the electron transport region ETR may be arranged under the plurality of stacks ST1 and ST2 the hole transport region HTR may be arranged on the upper portion of the plurality of stacks ST1 and ST2 with respect to the direction in which the light is emitted.

The light emitting element ED-a according to one or more embodiments may include a charge generation layer CGL1 arranged between the plurality of light emitting stacks ST1 and ST2. The light emitting element ED-a according to one or more embodiments may include a first charge generation layer CGL1 arranged between a first light emitting stack ST1 and a second light emitting stack ST2.

Referring to FIG. 5B, the light emitting element ED-a according to one or more embodiments may include the first electrode EL1, the first light emitting stack ST1, the first charge generation layer CGL1, the second light emitting stack ST2, and the second electrode EL2. In the light emitting element ED-a, each of the first light emitting stack ST1, the first charge generation layer CGL1, and the second light emitting stack ST2 may be provided as a common layer. Because the first and second emission layers EML1 and EML2 provided as the common layer may be deposited without a mask, a pixel having a smaller area may be formed. In the display panel DP according to one or more embodiments, many pixels having a smaller area are arranged on a plane, and thus high resolution may be achieved.

In the light emitting element ED-a of one or more embodiments, each of the first and second light emitting stacks ST1 and ST2 includes an emission layer and a plurality of functional layers. The first light emitting stack ST1 may include a first emission layer EML1, a hole transport region HTR arranged between the first electrode EL1 and the first emission layer EML1, and a first middle electron transport region arranged between the first emission layer EML1 and the first charge generation layer CGL1. The second light emitting stack ST2 may include a second emission layer EML2, a first middle hole transport region MHTR1 arranged between the first charge generation layer CGL1 and the second emission layer EML2, and an electron transport region ETR arranged between the second electrode EL2 and the second emission layer EML2.

In the light emitting element ED-a of one or more embodiments, each of the plurality of light emitting stacks ST1 and ST2 may include an emission layer. In one or more embodiments, the first light emitting stack ST1 may include a first emission layer EML1 that emits light of a first wavelength, and the second light emitting stack ST2 may include a second emission layer EML2 that emits light of a second wavelength different from the first wavelength. The light emitting element ED-a including the first emission layer EML1 and the second emission layer EML2 that generate light in different wavelength regions may be to emit white light.

The hole transport region HTR may serve to transport holes provided from the first electrode EL1 to the first emission layer EML1. The hole transport region HTR may include a hole injection layer HIL arranged on the first electrode EL1 and a hole transport layer HTL arranged on the hole injection layer HIL. However, one or more embodiments of the present disclosure is not limited thereto, and the hole transport region HTR may further include a hole-side additional layer arranged on the hole transport layer HTL. The hole side additional layer may include at least one of a hole buffer layer, an emission-auxiliary layer, or an electron blocking layer. The hole buffer layer may compensate for a resonance distance according to the wavelength of light emitted from the emission layer to thus increase luminous efficiency. The electron blocking layer may serve to prevent or reduce electron injection from the electron transport region into the hole transport region.

The first middle electron transport region may include a first middle electron transport layer METL1 arranged on the first emission layer EML1. The first middle electron transport layer METL1 may be arranged between the first emission layer EML1 and the first charge generation layer CGL1, and may be in contact with each of the first emission layer EML1 and the first charge generation layer CGL1. However, one or more embodiments of the present disclosure is not limited thereto, and the first middle electron transport region may further include a middle electron-side additional layer arranged between the first middle electron transport layer METL1 and the first emission layer EML1. The first middle electron-side additional layer may include at least one of an electron buffer layer or a hole blocking layer. In some embodiments, a first middle electron injection layer may be arranged between the first middle electron transport layer METL1 and the first charge generation layer CGL1.

The second light emitting stack ST2 may include a first middle hole transport region MHTR1 that transports, to the second emission layer EML2, holes generated from the first charge generation layer CGL1, and an electron transport region ETR that transports, to the second emission layer EML2, electrons provided from the second electrode EL2.

The first middle hole transport region MHTR1 may include a first middle hole transport layer MHTL1 arranged on the first charge generation layer CGL1. The first middle hole transport layer MHTL1 may be in contact with the lower surface of the second emission layer EML2. However, one or more embodiments of the present disclosure is not limited thereto, and the first middle hole transport region MHTR1 may further include a first middle hole-side additional layer arranged on the first middle hole transport layer MHTL1. The first middle hole-side additional layer may include at least one of a hole buffer layer, an emission auxiliary layer, or an electron blocking layer.

The electron transport region ETR may include an electron transport layer ETL arranged on the second emission layer EML2 and an electron injection layer EIL arranged on the electron transport layer ETL. The electron transport layer ETL may be in contact with the upper surface of the second emission layer EML2. However, one or more embodiments of the present disclosure is not limited thereto, and the electron transport region ETR may further include an electron-side additional layer arranged between the electron transport layer ETL and the second emission layer EML2. The electron-side additional layer may include at least one of an electron buffer layer or a hole blocking layer.

In the light emitting element ED-a of one or more embodiments, at least one of the hole transport region HTR or the first middle hole transport region MHTR1 includes hole transport auxiliary layers HTAL1 and HTAL2. The hole transport auxiliary layers HTAL1 and HTAL2 may include a hole transporting material and a fluorine-containing compound. The hole transport auxiliary layers HTAL1 and HTAL2 may include a first amine compound and a first fluorine-containing compound. In one or more embodiments, the hole transport auxiliary layers HTAL1 and HTAL2 may not include (e.g., may exclude) a (e.g., any) p-dopant material.

In the light emitting element ED-a of one or more embodiments, the hole transport auxiliary layers HTAL1 and HTAL2 may be arranged adjacent to at least one of the hole injection layer HIL or the first p-type (kind) charge generation layer p-CGL1. For example, the light emitting element ED-a of one or more embodiments may include hole transport auxiliary layers HTAL1 and HTAL2 in contact with at least one of the hole injection layer HIL or the first p-type (kind) charge generation layer p-CGL1. In one or more embodiments, in the present specification, the phrase "in contact with" may refer to that there are no intervening layers, films, regions, plates, and/or the like between a part such as a layer, a film, a region, and a plate and another part. For example, the phrase "in contact with" may refer to being arranged between two layers or two members without using an additional member, such as a separate functional layer or an adhesive member.

The hole transport auxiliary layers HTAL1 and HTAL2 may be layers that block a current path in the horizontal direction and facilitate a current path in the vertical direction in the light emitting element ED-a. For example, the hole transport auxiliary layers HTAL1 and HTAL2 may be configured to provide a vertical conduction path between the hole injection layer HIL or the p-type (kind) charge generation layer p-CGL and the hole transport layers HTL and MHTL1.

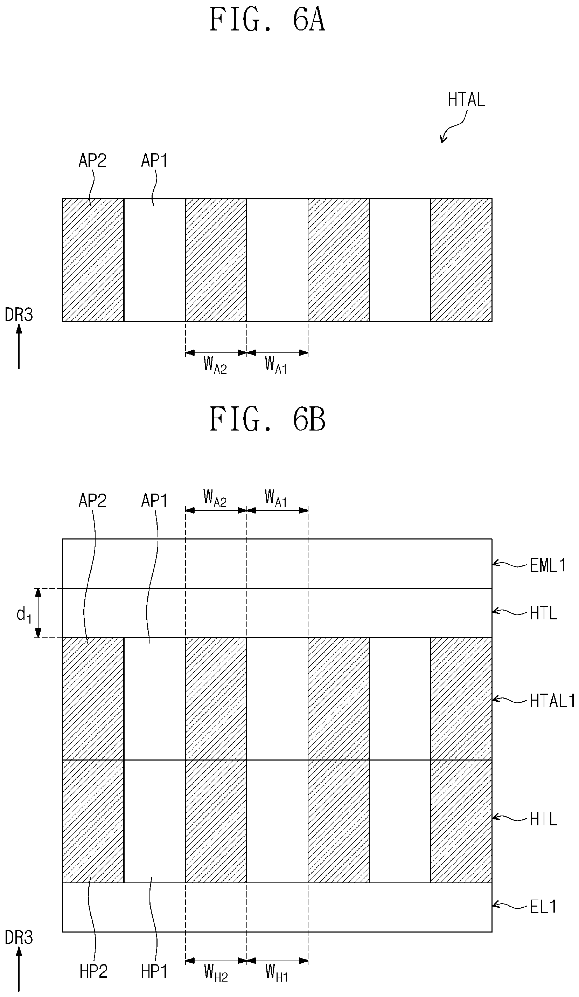

As illustrated in FIG. 5B, the light emitting element ED-a of one or more embodiments may include a first hole transport auxiliary layer HTAL1 arranged adjacent to the hole injection layer HIL and a second hole transport auxiliary layer HTAL2 arranged adjacent to the first p-type (kind) charge generation layer p-CGL1. The first hole transport auxiliary layer HTAL1 may be arranged between the hole injection layer HIL and the hole transport layer HTL. The first hole transport auxiliary layer HTAL1 may be arranged directly on the hole injection layer HIL. For example, the lower surface of the first hole transport auxiliary layer HTAL1 may be in contact with the upper surface of the hole injection layer HIL. The second hole transport auxiliary layer HTAL2 may be arranged between the first p-type (kind) charge generation layer p-CGL1 and the first middle hole transport layer MHTL1. The second hole transport auxiliary layer HTAL2 may be arranged directly on the first p-type (kind) charge generation layer p-CGL1. For example, the lower surface of the second hole transport auxiliary layer HTAL2 may be in contact with the upper surface of the first p-type (kind) charge generation layer p-CGL1. However, one or more embodiments of the present disclosure is not limited thereto, and unlike the configuration illustrated in FIG. 5B, the first hole transport auxiliary layer HTAL1 adjacent to the hole injection layer HIL may not be provided, and only the second hole transport auxiliary layer HTAL2 adjacent to the first p-type (kind) charge generation layer p-CGL1 may be provided. In some embodiments, the second hole transport auxiliary layer HTAL2 adjacent to the first p-type (kind) charge generation layer p-CGL1 may not be provided, and only the first hole transport auxiliary layer HTAL1 adjacent to the hole injection layer HIL may be provided. The details of the hole transport auxiliary layer will be described in more detail later with reference to FIGS. 6A to 6C.

In one or more embodiments, a layer of the hole injection layer HIL or the p-type (kind) charge generation layer p-CGL1, the layer being adjacent to the hole transport auxiliary layers HTAL1 and HTAL2, may include a p-dopant, a hole transporting material, and a fluorine-containing compound. In the light emitting element ED-a of one or more embodiments, a layer of the hole injection layer HIL or the first p-type (kind) charge generation layer p-CGL1, the layer being adjacent to the hole transport auxiliary layers HTAL1 and HTAL2, includes a p-dopant, a second amine compound, and a second fluorine-containing compound. In the light emitting element ED-a of one or more embodiments, a layer of the hole injection layer HIL or the first p-type (kind) charge generation layer p-CGL1, the layer being in contact with the hole transport auxiliary layers HTAL1 and HTAL2, may include a p-dopant, a second amine compound, and a second fluorine-containing compound. For example, if (e.g., when) the light emitting element ED-a of one or more embodiments includes the first hole transport auxiliary layer HTAL1 in contact with the hole injection layer HIL, the hole injection layer HIL may include a p-dopant, a second amine compound, and a second fluorine-containing compound. In some embodiments, if (e.g., when) the light emitting element ED-a of one or more embodiments includes the second hole transport auxiliary layer HTAL2 in contact with the first p-type (kind) charge generation layer p-CGL1, the first p-type (kind) charge generation layer p-CGL1 may include a p-dopant, a second amine compound, and a second fluorine-containing compound. In some embodiments, if (e.g., when) the light emitting element ED-a includes the first hole transport auxiliary layer HTAL1 in contact with the hole injection layer HIL and the second hole transport auxiliary layer HTAL2 in contact with the first p-type (kind) charge generation layer p-CGL1, the hole injection layer HIL and the first p-type (kind) charge generation layer p-CGL1 may each independently include a p-dopant, a second amine compound, and a second fluorine-containing compound.

In one or more embodiments, the first amine compound and the second amine compound may be the same as or different from each other. For example, the first amine compound included in the first hole transport auxiliary layer HTAL1 and the second amine compound included in the hole injection layer HIL may be the same as or different from each other. In some embodiments, the first amine compound included in the second hole transport auxiliary layer HTAL2 and the second amine compound included in the first p-type (kind) charge generation layer p-CGL1 may be the same as or different from each other.

In one or more embodiments, the first fluorine-containing compound and the second fluorine-containing compound may be the same as or different from each other. For example, the first fluorine-containing compound included in the first hole transport auxiliary layer HTAL1 and the second fluorine-containing compound included in the hole injection layer HIL may be the same as or different from each other. In some embodiments, the first fluorine-containing compound included in the second hole transport auxiliary layer HTAL2 and the second fluorine-containing compound included in the first p-type (kind) charge generation layer p-CGL1 may be the same as or different from each other.

The light emitting element ED-b illustrated in FIG. 5C differs from the light emitting element ED-a illustrated in FIG. 5B in the number of light emitting stacks included in the light emitting element. Unlike the configuration illustrated in FIG. 5B, the light emitting element ED-b of one or more embodiments illustrated in FIG. 5C differs from the light emitting element ED-a in terms of including three light emitting stacks ST1, ST2, and ST3.

Referring to FIG. 5C, the light emitting element ED-b according to one or more embodiments of the present disclosure may include a first electrode EL1, a second electrode EL2 opposite to (e.g., facing) the first electrode EL1, three light emitting stacks ST1, ST2, and ST3 arranged between the first electrode EL1 and the second electrode EL2, and charge generation layers CGL1 and CGL2 arranged between sequential pairs of the three light emitting stacks ST1, ST2, and ST3, respectively. The first charge generation layer CGL1 may be arranged between the first light emitting stack ST1 and the second light emitting stack ST2. The second charge generation layer CGL2 may be arranged between the second light emitting stack ST2 and the third light emitting stack ST3.

The first and second charge generation layers CGL1 and CGL2 may include n-type (kind) charge generation layers n-CGL1 and n-CGL2 and p-type (kind) charge generation layers p-CGL1 and p-CGL2, respectively. The first charge generation layer CGL1 may include a first n-type (kind) charge generation layer n-CGL1 arranged on the first light emitting stack ST1, and a first p-type (kind) charge generation layer p-CGL1 arranged on the first n-type (kind) charge generation layer n-CGL1. The second charge generation layer CGL2 may include a second n-type (kind) charge generation layer n-CGL2 and a second p-type (kind) charge generation layer p-CGL2 arranged on the second n-type (kind) charge generation layer n-CGL2.

In the light emitting element ED-b of one or more embodiments, a hole transport region HTR may be arranged between the first electrode EL1 and the first emission layer EML1. An electron transport region ETR may be arranged between the second electrode EL2 and a third emission layer EML3. The plurality of light emitting stacks ST1, ST2, and ST3 may include emission layers EML1, EML2, and EML3, respectively, and may include middle hole transport regions MHTR1 and MHTR2 and/or middle electron transport regions arranged between one of the emission layers EML1, EML2, and EML3 and one of the charge generation layers CGL1 and CGL2 adjacent thereto.

In the light emitting element ED-b of one or more embodiments, each of the plurality of light emitting stacks ST1, ST2, and ST3 may include an emission layer. In one or more embodiments, the first light emitting stack ST1 may include a first emission layer EML1 that emits light of a first wavelength, the second light emitting stack ST2 may include a second emission layer EML2 that emits light of a second wavelength different from the first wavelength, and the third light emitting stack ST3 may include a third emission layer EML3 that emits light of a third wavelength different from the first wavelength and the second wavelength. The light emitting element ED-b including the first to third emission layers EML1, EML2, and EML3 generating light in different wavelength regions may be to emit white light.

In the light emitting element ED-b, each of the first light emitting stack ST1, the first charge generation layer CGL1, the second light emitting stack ST2, the second charge generation layer CGL2, and the third light emitting stack ST3 may be provided as a common layer. Because the first to third emission layers EML1, EML2, and EML3 provided as the common layer may be deposited without a mask, a pixel having a smaller area may be formed. In the display panel DP (see FIG. 2B) according to one or more embodiments, many pixels having a smaller area are arranged on a plane, and thus high resolution may be achieved.

In the light emitting element ED-b of one or more embodiments, each of the first to third light emitting stacks ST1, ST2, and ST3 includes an emission layer and a plurality of functional layers.

The first light emitting stack ST1 may include a first emission layer EML1, a hole transport region HTR arranged between the first electrode EL1 and the first emission layer EML1, and a first middle electron transport region arranged between the first emission layer EML1 and the first charge generation layer CGL1. The hole transport region HTR may include a hole injection layer HIL arranged on the first electrode EL1 and a hole transport layer HTL arranged on the hole injection layer HIL. The first middle electron transport region may include a first middle electron transport layer METL1 arranged on the first emission layer EML1. The description in FIG. 5B may be equally applied to the hole transport region HTR and the first middle electron transport layer METL1 illustrated in FIG. 5C.

The second light emitting stack ST2 may include a second emission layer EML2, a first middle hole transport region MHTR1 arranged between the first charge generation layer CGL1 and the second emission layer EML2, and a second middle electron transport region arranged between the second charge generation layer CGL2 and the second emission layer EML2. The first middle hole transport region MHTR1 may include a first middle hole transport layer MHTL1 arranged on the first charge generation layer CGL1. The description in FIG. 5B may be equally applied to the first middle hole transport region MHTR1 illustrated in FIG. 5C. The second middle electron transport region may include a second middle electron transport layer METL2 arranged on the second emission layer EML2. However, one or more embodiments of the present disclosure is not limited thereto, and the second middle electron transport region may further include a second middle electron-side additional layer arranged between the second middle electron transport layer METL2 and the second emission layer EML2. The second middle electron-side additional layer may include at least one of an electron buffer layer or a hole blocking layer. In some embodiments, a second middle electron injection layer may be arranged between the second middle electron transport layer METL2 and the second charge generation layer CGL2.

The third light emitting stack ST3 may include a third emission layer EML3, a second middle hole transport region MHTR2 arranged between the second charge generation layer CGL2 and the third emission layer EML3, and an electron transport region ETR arranged between the second electrode EL2 and the third emission layer EML3. The second middle hole transport region MHTR2 may include a second middle hole transport layer MHTL2 arranged on the second charge generation layer CGL2. The second middle hole transport layer MHTL2 may be in contact with the lower surface of the third emission layer EML3. However, one or more embodiments of the present disclosure is not limited thereto, and the second middle hole transport region MHTR2 may further include a second middle hole-side additional layer arranged on the second middle hole transport layer MHTL2. The second middle hole-side additional layer may include at least one of a hole buffer layer, an emission auxiliary layer, or an electron blocking layer. The electron transport region ETR may include an electron transport layer ETL arranged on the third emission layer EML3 and an electron injection layer EIL arranged on the electron transport layer ETL. The description in FIG. 5B may be equally applied to the electron transport region ETR illustrated in FIG. 5C.

In the light emitting element ED-b of one or more embodiments, at least one of the hole transport region HTR, the first middle hole transport region MHTR1, and/or the second middle hole transport region MHTR2 includes hole transport auxiliary layers HTAL1, HTAL2, and HTAL3. The hole transport auxiliary layers HTAL1, HTAL2, and HTAL3 may include a hole transporting material and a fluorine-containing compound. The hole transport auxiliary layers HTAL1, HTAL2, and HTAL3 may include a first amine compound and a first fluorine-containing compound. The hole transport auxiliary layers HTAL1, HTAL2, and HTAL3 may be arranged adjacent to at least one of the hole injection layer HIL or the first p-type (kind) charge generation layer p-CGL1. For example, the light emitting element ED-b of one or more embodiments may include hole transport auxiliary layers HTAL1, HTAL2, and HTAL3 in contact with at least one of the hole injection layer HIL or the p-type (kind) charge generation layers p-CGL1 and p-CGL2.

As illustrated in FIG. 5C, the light emitting element ED-b of one or more embodiments may include a first hole transport auxiliary layer HTAL1 arranged adjacent to the hole injection layer HIL, a second hole transport auxiliary layer HTAL2 arranged adjacent to the first p-type (kind) charge generation layer p-CGL1, and a third hole transport auxiliary layer HTAL3 arranged adjacent to the second p-type (kind) charge generation layer p-CGL2.

The first hole transport auxiliary layer HTAL1 may be arranged between the hole injection layer HIL and the hole transport layer HTL. The first hole transport auxiliary layer HTAL1 may be arranged directly on the hole injection layer HIL. For example, the lower surface of the first hole transport auxiliary layer HTAL1 may be in contact with the upper surface of the hole injection layer HIL. The second hole transport auxiliary layer HTAL2 may be arranged between the first p-type (kind) charge generation layer p-CGL1 and the first middle hole transport layer MHTL1. The second hole transport auxiliary layer HTAL2 may be arranged directly on the first p-type (kind) charge generation layer p-CGL1. For example, the lower surface of the second hole transport auxiliary layer HTAL2 may be in contact with the upper surface of the first p-type (kind) charge generation layer p-CGL1. The third hole transport auxiliary layer HTAL3 may be arranged between the second p-type (kind) charge generation layer p-CGL2 and the second middle hole transport layer MHTL2. The third hole transport auxiliary layer HTAL3 may be arranged directly on the second p-type (kind) charge generation layer p-CGL2. For example, the lower surface of the third hole transport auxiliary layer HTAL3 may be in contact with the upper surface of the second p-type (kind) charge generation layer p-CGL2. However, one or more embodiments of the present disclosure is not limited thereto, and unlike the configuration illustrated in FIG. 5B, at least one of the first to third hole transport auxiliary layers HTAL1, HTAL2, and/or HTAL3 may not be provided.

In one or more embodiments, a layer among the hole injection layer HIL and the p-type (kind) charge generation layers p-CGL1 and p-CGL2, the layer being adjacent to the hole transport auxiliary layers HTAL1, HTAL2, and HTAL3, may include a p-dopant, a hole transporting material, and/or a fluorine-containing compound. In the light emitting element ED-b of one or more embodiments, a layer among the hole injection layer HIL and the p-type (kind) charge generation layers p-CGL1 and p-CGL2, the layer being adjacent to the hole transport auxiliary layers HTAL1, HTAL2, and HTAL3, includes a p-dopant, a second amine compound, and a second fluorine-containing compound. For example, if (e.g., when) the light emitting element ED-b includes the first hole transport auxiliary layer HTAL1 in contact with the hole injection layer HIL, the hole injection layer HIL may include a p-dopant, a second amine compound, and a second fluorine-containing compound. In some embodiments, if (e.g., when) the light emitting element ED-b includes the second hole transport auxiliary layer HTAL2 in contact with the first p-type (kind) charge generation layer p-CGL1, the first p-type (kind) charge generation layer p-CGL1 may include a p-dopant, a second amine compound, and/or a second fluorine-containing compound. When the light emitting element ED-b includes the third hole transport auxiliary layer HTAL3 in contact with the second p-type (kind) charge generation layer p-CGL2, the second p-type (kind) charge generation layer p-CGL2 may include a p-dopant, a second amine compound, and/or a second fluorine-containing compound.

In the light emitting elements ED-a and ED-b of one or more embodiments, the hole injection layer HIL or the p-type (kind) charge generation layers p-CGL1, and p-CGL2 may be formed to be doped with a p-dopant material for relatively high charge mobility. When the hole injection layer HIL or the p-type (kind) charge generation layers p-CGL1 and p-CGL2 are formed as a common layer, they may act as a path for the movement of charges, resulting in a lateral leakage current in which charges flow into one pixel during driving of another pixel through the hole injection layer HIL or the p-type (kind) charge generation layers p-CGL1 and p-CGL2.

The light emitting elements ED-a and ED-b according to one or more embodiments of the present disclosure may include the hole transport auxiliary layers HTAL1 and HTAL2 arranged adjacent to at least one among (e.g., at least one selected from among) the hole injection layer HIL and the p-type (kind) charge generation layers p-CGL1 and p-CGL2 and including the first amine compound and the first fluorine-containing compound, and a layer among the hole injection layer HIL and the p-type (kind) charge generation layers p-CGL1, and p-CGL2, the layer being adjacent to the hole transport auxiliary layers HTAL1, HTAL2, and HTAL3, may include the second amine compound and the second fluorine-containing compound, thereby preventing or reducing the lateral leakage current from occurring.

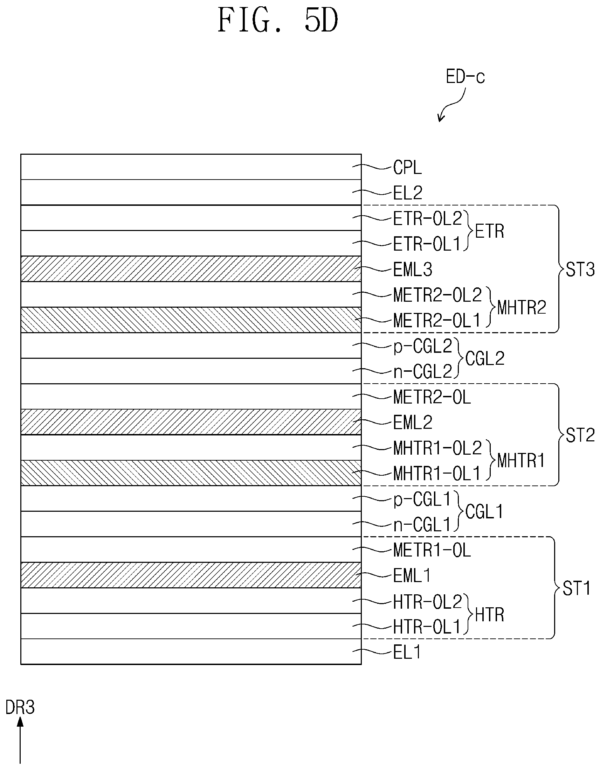

FIG. 5D illustrates the light emitting elements ED-a and ED-b of one or more embodiments illustrated in FIGS. 5B and 5C and the light emitting element ED-c of one or more embodiments. Hereinafter, in describing the light emitting element ED-c of one or more embodiments with reference to FIG. 5D, the same reference numerals are assigned to the same components as the herein-described components, and the detailed description thereof is omitted.

Referring to FIG. 5D, the light emitting element ED-c according to one or more embodiments may include a first electrode EL1, a second electrode EL2 opposite to (e.g., facing) the first electrode EL1, a plurality of light emitting stacks ST1, ST2, and ST3 arranged between the first electrode EL1 and the second electrode EL2, and charge generation layers CGL1 and CGL2 arranged between the plurality of light emitting stacks ST1, ST2, and ST3. FIG. 5D exemplarily illustrates that the light emitting element ED-c includes a total of three stacks ST1, ST2, and ST3, but one or more embodiments of the present disclosure is not limited thereto, and the light emitting element ED-c may include four or more stacks.

In one or more embodiments, the p-type (kind) charge generation layers p-CGL1 and p-CGL2 may include a p-type (kind) dopant. Each of the first p-type (kind) charge generation layer p-CGL1 included in the first charge generation layer CGL1 and the second p-type (kind) charge generation layer p-CGL2 included in the second charge generation layer CGL2 may include a p-type (kind) dopant. The preceding description in FIG. 5A may be equally applied to the p-type (kind) dopant.

In one or more embodiments, at least one among (e.g., at least one selected from among) the p-type (kind) charge generation layers p-CGL1 and p-CGL2 may include an amine compound and a fluorine-containing compound. For example, in the light emitting element ED-c illustrated in FIG. 5D, each of the first p-type (kind) charge generation layer p-CGL1 and the second p-type (kind) charge generation layer p-CGL2 may include an amine compound and a fluorine-containing compound.

The plurality of light emitting stacks ST1, ST2, and ST3 respectively includes emission layers EML1, EML2, and EML3 and a plurality of functional layers. Each of the hole transport region HTR and the middle electron transport region of the first light emitting stack ST1 may include at least one functional layer HTR-OL1, HTR-OL2, or METR1-OL. Each of the first middle hole transport region MHTR1 and the second middle electron transport region of the second light emitting stack ST2 may include at least one functional layer MHTR1-OL1, MHTR1-OL2, or METR2-OL. Each of the second middle hole transport region MHTR2 and the electron transport region ETR of the third light emitting stack ST3 may include at least one functional layer MHTR2-OL1, MHTR2-OL2, ETR-OL1, or ETR-OL2.

In one or more embodiments, at least one among (e.g., at least one selected from among) the functional layers MHTR1-OL1 and MHTR2-OL1, which is adjacent to the p-type (kind) charge generation layers p-CGL1 and p-CGL2 among the plurality of functional layers included in the plurality of light emitting stacks ST1, ST2, and ST3 may include an amine compound and a fluorine-containing compound. At least one among (e.g., at least one selected from among) the functional layers MHTR1-OL1 and MHTR2-OL1 in contact with the p-type (kind) charge generation layers p-CGL1 and p-CGL2 among the plurality of functional layers included in the plurality of light emitting stacks ST1, ST2, and ST3 may include an amine compound and a fluorine-containing compound. The light emitting element ED-c according to one or more embodiments of the present disclosure may include an amine compound and a fluorine-containing compound in the p-type (kind) charge generation layers p-CGL1 and p-CGL2, and may include a separate amine compound and a fluorine-containing compound in a functional layer formed to be in contact with the p-type (kind) charge generation layers p-CGL1 and p-CGL2.

The amine compound included in the p-type (kind) charge generation layers p-CGL1 and p-CGL2 may be the same as or different from the amine compound included in the adjacent functional layer. In some embodiments, the fluorine-containing compound included in the p-type (kind) charge generation layers p-CGL1 and p-CGL2 may be the same as or different from the fluorine-containing compound included in the adjacent functional layer.

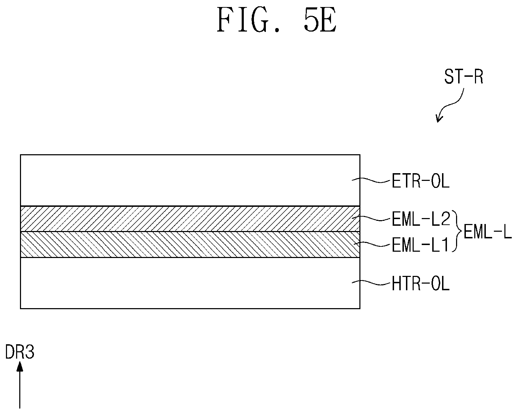

FIG. 5E illustrates one or more embodiments of one light emitting stack among the light emitting stacks included in the light emitting element of one or more embodiments.

At least one among (e.g., at least one selected from among) the light emitting stacks included in the light emitting elements ED, ED-a, ED-b, and ED-c illustrated in FIGS. 5A to 5D may have a structure of the light emitting stack ST-R illustrated in FIG. 5E. For example, in the light emitting element ED of one or more embodiments illustrated in FIG. 5A, at least one among (e.g., at least one selected from among) the plurality of light emitting stacks ST1, ..., STn may have the structure of the light emitting stack ST-R illustrated in FIG. 5E. In one or more embodiments, in the light emitting element ED-a of one or more embodiments illustrated in FIG. 5B, at least one among (e.g., at least one selected from among) the first and second light emitting stacks ST1 and ST2 may have the structure of the light emitting stack ST-R illustrated in FIG. 5E. In one or more embodiments, in the light emitting elements ED-b and ED-c of embodiments illustrated in FIGS. 5C and 5D, at least one among (e.g., at least one selected from among) the first to third light emitting stacks ST1, ST2, and ST3 may have the structure of the light emitting stack ST-R illustrated in FIG. 5E.

Referring to FIG. 5E, the light emitting stack ST-R may include a first organic layer HTR-OL, an emission layer EML-L arranged on the first organic layer HTR-OL, and a second organic layer ETR-OL arranged on the emission layer EML-L. The light emitting stack ST-R may include the first organic layer HTR-OL, the emission layer EML-L, and the second organic layer ETR-OL, which are sequentially stacked in a third direction DR3 that is the thickness direction.

The first organic layer HTR-OL may be the hole transport region HTR or the middle hole transport regions MHTR1, MHTR2, and MHTRn described herein with reference to FIGS. 5A to 5D. The second organic layer ETR-OL may be the electron transport region ETR or the middle electron transport region described herein with reference to FIGS. 5A to 5D.

The light emitting stack ST-R of one or more embodiments illustrated in FIG. 5E may include a plurality of emission layers EML-L1 and EML-L2. For example, the emission layer EML-L included in the light emitting stack ST-R may have a double layer structure. The plurality of emission layers EML-L1 and EML-L2 included in the light emitting stack ST-R may be to emit light in different wavelength ranges.

As illustrated in FIG. 5E, the light emitting stack ST-R of one or more embodiments may include a first sub-emission layer EML-L1 and a second sub-emission layer EML-L2. The first sub-emission layer EML-L1 and the second sub-emission layer EML-L2 may be in contact with each other. In the light emitting elements ED, ED-a, ED-b, and ED-c of embodiments, the first sub-emission layer EML-L1 may be arranged adjacent to the first electrode EL1, and the second sub-emission layer EML-L2 may be arranged adjacent to the second electrode EL2. In one or more embodiments, the first sub-emission layer EML-L1 may be to emit light of a first wavelength, and the second sub-emission layer EML-L2 may be to emit light of a second wavelength different from the first wavelength.

Referring to FIGS. 5A to 5D again, in the light emitting elements ED, ED-a, ED-b, and ED-c according to one or more embodiments, the first electrode EL1 has conductivity (e.g., is a conductor). The first electrode EL1 may be formed of a metal material, a metal alloy, or a conductive compound. The first electrode EL1 may be an anode or a cathode. However, one or more embodiments of the present disclosure is not limited thereto. In some embodiments, the first electrode EL1 may be a pixel electrode.

In the light emitting elements ED, ED-a, ED-b, and ED-c according to one or more embodiments, the first electrode EL1 may be a reflective electrode. For example, the first electrode EL1 may include Ag, Mg, Cu, Al, Pt, Pd, Au, Ni, Nd, Ir, Cr, Li, Ca, LiF/Ca, LiF/Al, Mo, Ti, W, In, Zn, Sn, or a compound or mixture thereof (e.g., a mixture of Ag and Mg) with the high reflectivity. In one or more embodiments, the first electrode EL1 may have a multilayer structure including a reflective film formed of the herein-described materials, and a transparent conductive film formed of indium tin oxide (ITO), indium zinc oxide (IZO), zinc oxide (ZnO), indium tin zinc oxide (ITZO), and/or the like. For example, the first electrode EL1 may have a two-layer structure of ITO/Ag and a three-layer structure of ITO/Ag/ITO, but one or more embodiments of the present disclosure is not limited thereto. In some embodiments, one or more embodiments of the present disclosure is not limited thereto, and the first electrode EL1 may include the herein-described metal materials, combinations of at least two metal materials of the herein-described metal materials, oxides of the herein-described metal materials, and/or the like. The first electrode EL1 may have a thickness of about 70 nm to about 1,000 nm. For example, the first electrode EL1 may have a thickness of about 100 nm to about 300 nm.

In the light emitting elements ED, ED-a, ED-b, and ED-c according to one or more embodiments, the hole transport region HTR and the middle hole transport regions MHTR1 and MHTR2 may each have a single layer formed of a single material, a single layer formed of a plurality of different materials, or a multi-layered structure including a plurality of layers formed of a plurality of different materials.

The hole transport regions HTR and the middle hole transport regions MHTR1 and MHTR2 may each be formed using one or more suitable methods such as a vacuum deposition method, a spin coating method, a cast method, a Langmuir-Blodgett (LB) method, an inkjet printing method, a laser printing method, a laser induced thermal imaging (LITI) method, and/or the like.

The hole transport region HTR and the middle hole transport regions MHTR1 and MHTR2 may each employ a general hole transport material suitable in the art without limitation.

The hole transport region HTR and the middle hole transport regions MHTR1 and MHTR2 may each independently include a compound represented by Formula H-1. For example, the hole transport auxiliary layers HTAL1 and HTAL2 may include an amine compound represented by Formula H-1 as the first amine compound. In one or more embodiments, the hole injection layer HIL and/or the p-type (kind) charge generation layers p-CGL1 and p-CGL2 may include an amine compound represented by Formula H-1 as the second amine compound.

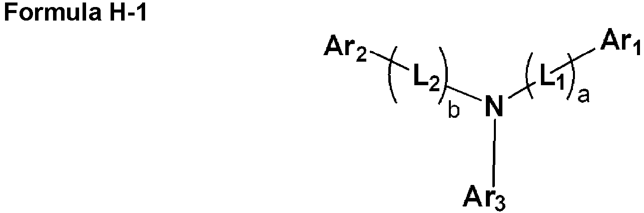

In Formula H-1, L₁ and L₂ may each independently be a direct linkage, a substituted or unsubstituted arylene group having 6 to 30 ring-forming carbon atoms, or a substituted or unsubstituted heteroarylene group having 2 to 30 ring-forming carbon atoms. a and b may each independently be an integer of 0 to 10. In one or more embodiments, if (e.g., when) a or b is an integer of 2 or greater, a plurality of L₁'s and L₂'s may each independently be a substituted or unsubstituted arylene group having 6 to 30 ring-forming carbon atoms, or a substituted or unsubstituted heteroarylene group having 2 to 30 ring-forming carbon atoms.

In Formula H-1, Ar₁ and Ar₂ may each independently be a substituted or unsubstituted aryl group having 6 to 30 ring-forming carbon atoms, or a substituted or unsubstituted heteroaryl group having 2 to 30 ring-forming carbon atoms. In some embodiments, in Formula H-1, Ar₃ may be a substituted or unsubstituted aryl group having 6 to 30 ring-forming carbon atoms, or a substituted or unsubstituted heteroaryl group having 2 to 30 ring-forming carbon atoms.

The compound represented by Formula H-1 may be a monoamine compound. In one or more embodiments, the compound represented by Formula H-1 may be a diamine compound in which at least one among (e.g., at least one selected from among) Ar₁ to Ar₃ includes the amine group as a substituent. In some embodiments, the compound represented by Formula H-1 may be a carbazole-based compound including a substituted or unsubstituted carbazole group in at least one of Ar₁ or Ar₂, or a fluorene-based compound including a substituted or unsubstituted fluorene group in at least one of Ar₁ or Ar₂.

The compound represented by Formula H-1 may be represented by any one among (e.g., selected from among) the compounds in Compound Group H. However, the compounds listed in Compound Group H are examples, and the compounds represented by Formula H-1 are not limited to those represented by Compound Group H:

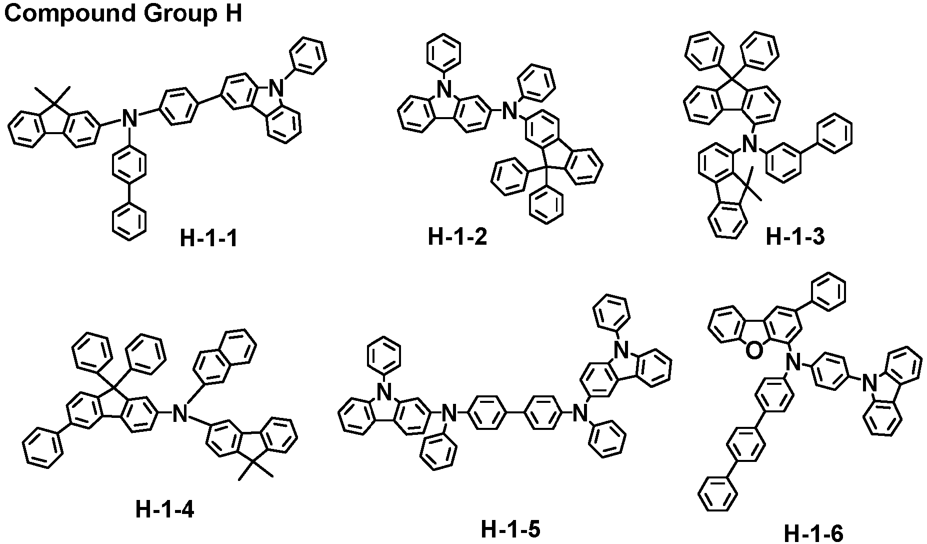

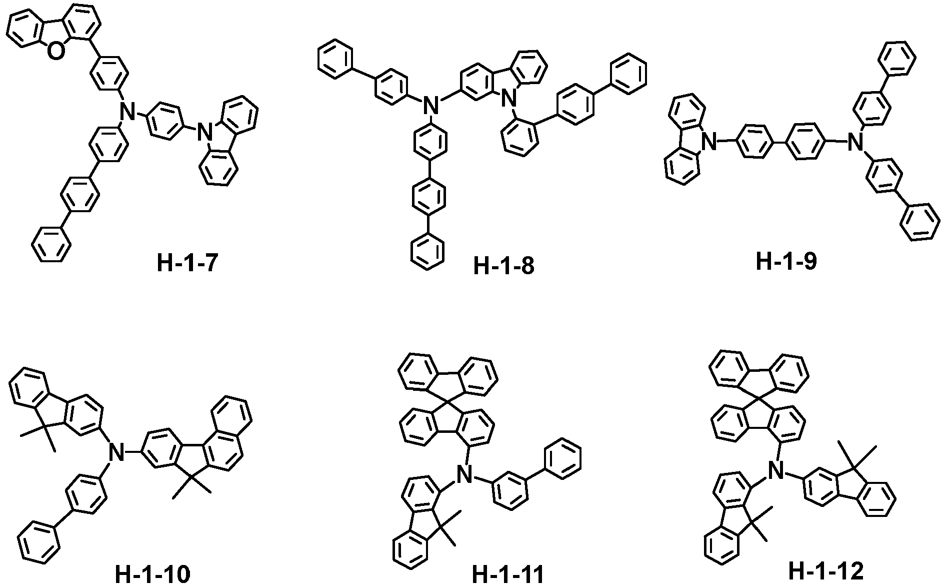

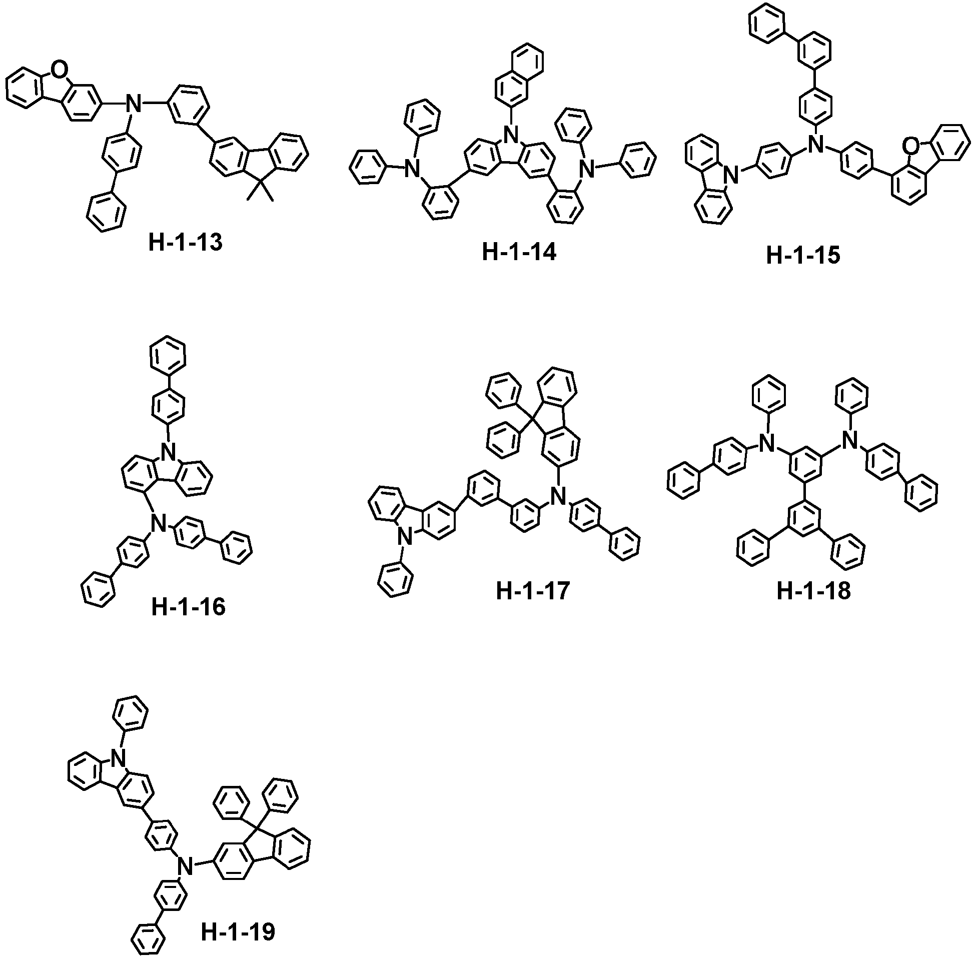

The hole transport region HTR and the middle hole transport regions MHTR1 and MHTR2 may each include a phthalocyanine compound such as copper phthalocyanine; *N*1,*N*1'-([1,1'-biphenyl]-4,4'-diyl)bis(*N*1-phenyl-*N*4,*N*4-di-m-tolylbenzene-1,4-diamine) (DNTPD), 4,4',4"-[tris(3-methylphenyl)phenylamino]triphenylamine] (m-MTDATA), 4,4',4"-tris(*N*,*N-*diphenylamino)triphenylamine (TDATA), 4,4',4"-tris[*N*(2-naphthyl)-*N*-phenylamino]-triphenylamine (2-TNATA), poly(3,4-ethylenedioxythiophene)/poly(4-styrenesulfonate) (PEDOT/PSS), polyaniline/dodecylbenzenesulfonic acid (PANI/DBSA), polyaniline/camphor sulfonic acid (PANI/CSA), polyaniline/poly(4-styrenesulfonate) (PANI/PSS), *N,N*'-di(naphthalene-l-yl)-*N,N*'-diphenyl-benzidine (NPB), triphenylamine-containing polyetherketone (TPAPEK), 4-isopropyl-4'-methyldiphenyliodonium [tetrakis(pentafluorophenyl)borate], dipyrazino[2,3-f: 2',3'-*h*]quinoxaline-2,3,6,7,10,11-hexacarbonitrile (HATCN), and/or the like.

In some embodiments, the hole transport region HTR and the middle hole transport regions MHTR1 and MHTR2 may each include carbazole derivatives such as N-phenyl carbazole and polyvinyl carbazole, fluorene derivatives, N,N'-bis(3-methylphenyl)-*N,N*'-diphenyl-[1,1-biphenyl]-4,4'-diamine (TPD), triphenylamine derivatives such as 4,4',4"-tris(N-carbazolyl)triphenylamine (TCTA), 4,4'-cyclohexylidene bis[*N,N*-bis(4-methylphenyl)benzenamine] (TAPC), 4,4'-bis[*N*,*N'*-(3-tolyl)amino]-3,3'-dimethylbiphenyl (HMTPD), 9-(4-tert-butylphenyl)-3,6-bis(triphenylsilyl)-9H-carbazole (CzSi), 9-phenyl-9H-3,9'-bicarbazole (CCP), 1,3-bis(*N-*carbazolyl)benzene (mCP), 1,3-bis(1,8-dimethyl-9*H*-carbazol-9-yl)benzene (mDCP), and/or the like.

Each of the first hole transport region HTR and the middle hole transport regions MHTR1 and MHTR2 may further include, in addition to the herein-described materials, a charge generating material to increase conductivity. The charge generating material may be dispersed uniformly (e.g., substantially uniformly) or non-uniformly (e.g., substantially non-uniformly) in the hole transport region HTR and the middle hole transport regions MHTR1 and MHTR2. The charge generating material may be, for example, a p-dopant. The p-dopant may include at least one of a halogenated metal compound, a quinone derivative, a metal oxide, or a cyano group-containing compound, but one or more embodiments of the present disclosure is not limited thereto. For example, the p-dopant may include a metal halide compound such as Cul or RbI, a quinone derivative such as tetracyanoquinodimethane (TCNQ) or 2,3,5,6-tetrafluoro-7,7'8,8-tetracyanoquinodimethane (F4-TCNQ), a metal oxide such as tungsten oxide or molybdenum oxide, a cyano group-containing compound such as dipyrazino[2,3-f: 2',3'-h] quinoxaline-2,3,6,7,10,11-hexacarbonitrile (HATCN) or 4-[[2,3-bis[cyano-(4-cyano-2,3,5,6-tetrafluorophenyl)methylidene]cyclopropylidene]-cyanomethyl]-2,3,5,6-tetrafluorobenzonitrile (NDP9), and/or the like, but one or more embodiments of the present disclosure is not limited thereto.

The hole transport region HTR may include the herein-described compounds of the hole transport region in at least one of the hole injection layer HIL, the hole transport layer HTL, or the hole-side additional layer. In some embodiments, if (e.g., when) the hole transport region HTR includes the hole transport auxiliary layer HTAL1, the first hole transport auxiliary layer HTAL1 may include the herein-described compounds of the hole transport region as a hole transporting material. The middle hole transport regions MHTR1 and MHTR2 may include the herein-described compounds of the hole transport region HTR in at least one among (e.g., at least one selected from among) the middle hole transport layers MHTL1 and MHTL2 and the middle hole-side additional layer. In some embodiments, if (e.g., when) the middle hole transport regions MHTR1 and MHTR2 include the hole transport auxiliary layers HTAL2 and HTAL3, the hole transport auxiliary layers HTAL2 and HTAL3 may include the herein-described compounds of the hole transport region HTR as a hole transporting material.

Each of the hole transport region HTR and the middle hole transport regions MHTR1 and MHTR2 may have a thickness of about 10 nanometers (nm) to about 1,000 nm, for example, about 10 nm to about 500 nm. The hole injection layer HIL may have a thickness of, for example, about 5 nm to about 100 nm. Each of the hole transport layer HTL and the middle hole transport layers MHTL1 and MHTL2 may have a thickness of about 5 nm to about 100 nm. The hole transport auxiliary layers HTAL1, HTAL2, and HTAL3 may have a thickness of about 5 nm to about 100 nm.

When the hole transport region HTR includes the hole-side additional layer, the hole-side additional layer may have a thickness of about 1 nm to about 100 nm. When the middle hole transport regions MHTR1 and MHTR2 include the middle hole-side additional layer, the middle hole-side additional layer may have a thickness of about 1 nm to about 100 nm. When the thicknesses of the hole transport region HTR and the middle hole transport regions MHTR1 and MHTR2 and the respective layers included therein satisfy the herein-described ranges, satisfactory hole transport properties may be obtained without a substantial increase in driving voltage.

The electron transport region ETR and the middle electron transport region is arranged on the emission layers EML1 and EML2, respectively. Each of the electron transport region ETR and the middle electron transport region may have a single layer formed of a single material, a single layer formed of a plurality of different materials, or a multi-layered structure including a plurality of layers formed of a plurality of different materials.

Each of the electron transport region ETR and the middle electron transport region may employ a general electron transporting material suitable in the art without limitation.

The electron transport region ETR and the middle electron transport region may each be formed using one or more suitable methods such as a vacuum deposition method, a spin coating method, a cast method, a Langmuir-Blodgett (LB) method, an inkjet printing method, a laser printing method, a laser induced thermal imaging (LITI) method, and/or the like.

For example, the electron transport region ETR and the middle electron transport region may each include an anthracene-based compound. However, one or more embodiments of the present disclosure is not limited thereto, and the electron transport region ETR may include, for example, tris(8-hydroxyquinolinato)aluminium (Alq₃), 1,3,5-tri[(3-pyridyl)-phen-3-yl]benzene, 2,4,6-tris(3'-(pyridin-3-yl)biphenyl-3-yl)-1,3,5-triazine, 2-(4-(*N*-phenylbenzoimidazol-1-yl)phenyl)-9,10-dinaphthylanthracene, 1,3,5-tri(1-phenyl-1*H*-benz[d]imidazol-2-yl)benzene (TPBi), 2,9-dimethyl-4,7-diphenyl-1,10-phenanthroline (BCP), 4,7-diphenyl-1,10-phenanthroline (Bphen), 3-(4-biphenylyl)-4-phenyl-5-*tert*-butylphenyl-1,2,4-triazole (TAZ), 4-(naphthalen-1-yl)-3,5-diphenyl-4*H*-1,2,4-triazole (NTAZ), 2-(4-biphenylyl)-5-(4-*tert*-butylphenyl)-1,3,4-oxadiazole (tBu-PBD), bis(2-methyl-8-quinolinolato-*N*1,08)-(1,1'-biphenyl-4-olato)aluminium (BAlq), beryllium bis(benzoquinolin-10-olate) (Bebq₂), 9,10-di(naphthalen-2-yl)anthracene (ADN), 1,3-bis[3,5-di(pyridin-3-yl)phenyl]benzene (BmPyPhB), and/or a (e.g., any suitable) mixture thereof.

In some embodiments, the electron transport region ETR and the middle electron transport region may each include a metal halide such as LiF, NaCl, CsF, RbCl, RbI, Cul, KI, and/or the like, a lanthanide metal such as Yb, and/or a co-deposited material of the metal halide and/or the lanthanide metal. For example, the electron transport region ETR may include KI:Yb, RbI:Yb, LiF:Yb, and/or the like, as a co-deposited material. In one or more embodiments, the electron transport region ETR may be formed using a metal oxide such as Li₂O and/or BaO, and/or 8-hydroxyl-lithium quinolate (Liq), and/or the like, but one or more embodiments of the present disclosure is not limited thereto. The electron transport region ETR may also be formed of a mixture material of an electron transport material and an insulating organometallic salt. The organometallic salt may be a material having an energy band gap of about 4 eV or more. For example, the organometallic salt may include, for example, a metal acetate, a metal benzoate, a metal acetoacetate, a metal acetylacetonate, or a metal stearate.

The electron transport region ETR and the middle electron transport region may each further include at least one of 2,9-dimethyl-4,7-diphenyl-1,10-phenanthroline (BCP), diphenyl(4-(triphenylsilyl)phenyl)phosphine oxide (TSPO1), or 4,7-diphenyl-1,10-phenanthroline (Bphen) in addition to the herein-described materials, but one or more embodiments of the present disclosure is not limited thereto.

The electron transport region ETR may include the herein-described compounds of the electron transport region in the electron injection layer EIL or the electron transport layer ETL. When the electron transport region ETR includes the electron-side additional layer, the herein-described materials may be included in the electron-side additional layer. The middle electron transport region may include the herein-described compounds of the electron transport region in the middle electron transport layers METL1 and METL2. The middle electron transport region may include the herein-described compounds of the electron transport region in the middle electron-side additional layer or the middle electron injection layer.

Each of the electron transport region ETR and the middle electron transport region may have a thickness of, for example, about 100 nm to about 150 nm. The electron transport layer ETL may have a thickness of about 0.1 nm to about 100 nm, for example, about 0.3 nm to about 50 nm. If the thickness of the electron transport layer ETL satisfies the aforementioned range, satisfactory electron transport characteristics may be obtained without a substantial increase in driving voltage. The electron injection layer EIL may have a thickness of about 0.1 nm to about 10 nm, and about 0.3 nm to about 9 nm. If the thickness of the electron injection layer EIL satisfies the herein-described range, satisfactory electron injection characteristics may be obtained without a substantial increase in driving voltage. The middle electron transport layers METL1 and METL2 included in the middle electron transport region may have a thickness of about 0.1 nm to about 100 nm, for example, about 0.1 nm to about 50 nm.

The second electrode EL2 may include at least one selected from among Ag, Mg, Cu, Al, Pt, Pd, Au, Ni, Nd, Ir, Cr, Li, Ca, LiF, Mo, Ti, W, In, Sn, and Zn, a compound of two or more selected from among these, a mixture of two or more selected from among these, or an oxide thereof. The second electrode EL2 may be a transmissive electrode, a transflective electrode, or a reflective electrode. When the second electrode EL2 is the transmissive electrode, the second electrode EL2 may be formed of a transparent metal oxide such as indium tin oxide (ITO), indium zinc oxide (IZO), zinc oxide (ZnO), or indium tin zinc oxide (ITZO).

When the second electrode EL2 is the transflective electrode or the reflective electrode, the second electrode EL2 may include Ag, Mg, Cu, Al, Pt, Pd, Au, Ni, Nd, Ir, Cr, Li, Ca, LiF/Ca, LiF/Al, Mo, Ti, Yb, W, or a compound or mixture thereof (*e*.*g*., AgMg, AgYb, or MgYb). In one or more embodiments, the second electrode EL2 may have a multi-layered structure including a reflective film or a transflective film formed of the herein-described materials, and a transparent conductive film formed of ITO, IZO, ZnO, ITZO, and/or the like. For example, the second electrode EL2 may include the herein-described metal materials, combinations of at least two metal materials of the herein-described metal materials, oxides of the herein-described metal materials, and/or the like.

FIG. 6A is a cross-sectional view of a hole transport auxiliary layer included in a light emitting element of one or more embodiments. The structure of the hole transport auxiliary layer HTAL illustrated in FIG. 6A may be equally applied to each of the hole transport auxiliary layers HTAL1, HTAL2, and HTAL3 illustrated in FIGS. 5A to 5C. In some embodiments, the structure of the hole transport auxiliary layer HTAL illustrated in FIG. 6A may be equally applied to a functional layer including an amine compound and a fluorine-containing compound among the functional layers MHTR1-OL1 and MHTR2-OL1, the functional layer being adjacent to the p-type (kind) charge generation layers p-CGL1 and p-CGL2 illustrated in FIG. 5D.

Referring to FIG. 6A, the first amine compound and the first fluorine-containing compound may be composed to be phase-separated in the hole transport auxiliary layer HTAL. In the hole transport auxiliary layer HTAL, the first amine compound and the first fluorine-containing compound may be provided while being phase-separated from each other in a direction normal (e.g., perpendicular) to the third direction DR3. In the present specification, the term "phase-separated" refers to that the distribution of a specific component included in a film due to a difference in the density, surface tension, or other physical properties of the components becomes different from those of other components. Here, if (e.g., when) the hole transport auxiliary layer HTAL is phase-separated, it may be divided into at least two portions based on a distribution difference of a specific component, for example, a distribution difference of a fluorine-containing compound.

The hole transport auxiliary layer HTAL may include a plurality of first portions AP1 including the first amine compound and a plurality of second portions AP2 including the first fluorine-containing compound. In one or more embodiments, each of the first portions AP1 may not include (e.g., may exclude) a p-dopant. In one or more embodiments, the plurality of first portions AP1 and the plurality of second portions AP2 may be alternately arranged in a direction normal (e.g., perpendicular) to the thickness direction. The plurality of first portions AP1 and the plurality of second portions AP2 may be alternately arranged in a direction normal (e.g., perpendicular) to the third direction DR3. In the hole transport auxiliary layer HTAL, the second portions AP2 may be arranged between neighboring first portions AP1 in the direction normal (e.g., perpendicular) to the third direction DR3.

Each of the plurality of first portions AP1 and the plurality of second portions AP2 may have a shape extending in the third direction DR3, which is the thickness direction. In one or more embodiments, although FIG. 6A exemplarily illustrates that the hole transport auxiliary layer HTAL includes three first portions AP1 and four second portions AP2, one or more embodiments of the present disclosure is not limited thereto.

The plurality of first portions AP1 including the first amine compound in the hole transport auxiliary layer HTAL1 may correspond to a path through which charges move. For example, in the light emitting element LD, a current may flow in the third direction DR3, which is the thickness direction, through the first portions AP1. The second portions AP2 including the first fluorine-containing compound in the hole transport auxiliary layer HTAL1 may exhibit insulating properties. Accordingly, a current flow in the hole transport auxiliary layer HTAL1 may be induced to be limited to the first portions AP1. The second portion AP2 is arranged between the first portions AP1 adjacent thereto in the direction normal (e.g., perpendicular) to the thickness direction, thereby preventing or reducing lateral leakage current from occurring between adjacent pixels.

In one or more embodiments, in the present specification, the term "lateral leakage current" refers to a current flowing in a direction crossing the third direction DR3 other than a current flowing in the third direction DR3, which is the stacking direction of the light emitting element, that is, in the direction in which the image is displayed. The lateral leakage current may refer to a current flowing in a direction parallel to a plane defined by the first direction DR1 (see FIG. 3) and the second direction DR2 (see FIG. 3).

In one or more embodiments, the first fluorine-containing compound may be a material containing fluorine. For example, the first fluorine-containing compound may include at least one fluoropolymer, e.g., at least one of TEFLON (e.g., Teflon polymer or PTFE (polytetrafluoroethylene) polymer) or CYTOP (e.g., Cytop (cyclized transparent optical polymer).

In one or more embodiments, the hole transport auxiliary layer HTAL may be formed using a vacuum deposition method. The hole transport auxiliary layer HTAL may be formed by concurrently (e.g., simultaneously) depositing the first amine compound and the first fluorine-containing compound. For example, the hole transport auxiliary layer HTAL may be formed by co-depositing the first amine compound and the first fluorine-containing compound on a substrate to be deposited. When the first amine compound and the first fluorine-containing compound are co-deposited, the first amine compound and the first fluorine-containing compound may be phase-separated on the substrate to form the plurality of first portions AP1 and the plurality of second portions AP2.

In one or more embodiments, the water contact angle of the first fluorine-containing compound may be about 110° or more. When the water contact angle of the first fluorine-containing compound is about 110° or more, with respect to the target substrate if (e.g., when) co-depositing the organic material containing the amine compound with the fluorine-containing compound, alternately stacking in a horizontal direction may be possible. When the water contact angle of the first fluorine-containing compound is less than about 110°, it is difficult to arrange the organic material containing the amine compound and the fluorine-containing compound in the vertical direction, so that it may be difficult to provide a vertical current path in the film, and the leakage current blocking effect may be deteriorated. In one or more embodiments, in the present specification, increasing the water contact angle may refer to that the free energy of the film surface is lowered, that is, hydrophobicized, and decreasing the water contact angle may refer to that the free energy of the film surface is increased, that is, hydrophilicized. The water contact angle can be measured by a Drop shape analyzer DSA100, Kruss GmbH, Germany.

In one or more embodiments, in order for the first fluorine-containing compound not to impair the hole transport properties of the first amine compound in the hole transport auxiliary layer HTAL, the lowest unoccupied molecular orbital (LUMO) level of the first fluorine-containing compound may be about 5.0 electron volt (eV) or less. When the lowest unoccupied molecular orbital (LUMO) level of the first fluorine-containing compound is greater than about 5.0 eV, the hole transport properties of the first amine compound may be deteriorated. The lowest unoccupied molecular orbital (LUMO) energy (eV) can be measured by using a cyclic voltammetry.

In one or more embodiments, a mass ratio of the first amine compound and the first fluorine-containing compound in the hole transport auxiliary layer HTAL1 may be about 3:7 to about 5:5. In the hole transport auxiliary layer HTAL, a mass ratio of the first amine compound and the first fluorine-containing compound may be about 3:7 to about 5:5. When the mass ratio of the first amine compound and the first fluorine-containing compound satisfies the herein-described range, the phase separation of the first amine compound and the first fluorine-containing compound in the horizontal direction may effectively occur in the hole transport auxiliary layer HTAL1.

In one or more embodiments, the first fluorine-containing compound may have an average molecular weight of about 300 g/mol to about 5,000 g/mol. When the average molecular weight of the first fluorine-containing compound is less than about 300 g/mol, the compound may be pyrolyzed by a high temperature during the vacuum deposition process, thereby deteriorating film durability. In some embodiments, if (e.g., when) the average molecular weight of the first fluorine-containing compound is greater than about 5,000 g/mol, the vacuum deposition temperature may be increased due to the high molecular weight, and thus it may be unsuitable for film formation by co-deposition. When the average molecular weight of the first fluorine-containing compound satisfies the herein-described range, it may be applied to a vacuum deposition process while maintaining the thermal stability of the material, thereby further improving the film durability. In one or more embodiments, in the present specification, the average molecular weight may refer to a number average molecular weight.

In the hole transport auxiliary layer HTAL, each of the first width W_{A1} of the first portion AP1 and the second width W_{A2} of the second portion AP2 may be determined by a difference in surface energy between the target substrate and the first fluorine-containing compound, a weight ratio of the first amine compound and the first fluorine-containing compound, and/or the like. The first width W_{A1} of the first portion AP1 may refer to a minimum width of the first portion AP1 measured in the direction normal (e.g., perpendicular) to the third direction DR3, and the second width W_{A2} of the second portion AP2 may refer to a minimum width of the second portion AP2 measured in the direction normal (e.g., perpendicular) to the third direction DR3.

FIG. 6B is a cross-sectional view illustrating a partial configuration of a light emitting element of one or more embodiments. FIG. 6B illustrates only a partial configuration of the light emitting elements ED-a and ED-b illustrated in FIGS. 5B and 5C. FIG. 6B illustrates the first electrode EL1, the hole injection layer HIL, the first hole transport auxiliary layer HTAL1, the hole transport layer HTL, and the first emission layer EML1 illustrated in FIGS. 5B and 5C, and the remaining layers are omitted. Hereinafter, in describing the light emitting element according to one or more embodiments of the present disclosure with reference to FIG. 6B, the same reference numerals will be given to the components described herein with reference to FIGS. 5A to 5D and 6A, and detailed descriptions thereof will not be provided.

Referring to FIG. 6B, the light emitting element ED of one or more embodiments may include the first hole transport auxiliary layer HTAL1 adjacent to the hole injection layer HIL. The first hole transport auxiliary layer HTAL1 may be arranged in contact with the hole injection layer HIL. In one or more embodiments, the first hole transport auxiliary layer HTAL1 may include a first amine compound and a first fluorine-containing compound, and the hole injection layer HIL may include a p-dopant, a second amine compound, and a second fluorine-containing compound.

In the hole injection layer HIL, the second amine compound and the second fluorine-containing compound may be composed to be phase-separated. In the hole injection layer HIL, the second amine compound and the second fluorine-containing compound may be provided while being phase-separated from each other in a direction normal (e.g., perpendicular) to the third direction DR3.

The hole injection layer HIL may include a plurality of third portions HP1 including the second amine compound and the p-dopant, and a fourth portion HP2 including the second fluorine-containing compound. In one or more embodiments, the plurality of third portions HP1 and the plurality of fourth portions HP2 may be alternately arranged in a direction normal (e.g., perpendicular) to the thickness direction. In the hole injection layer HIL, the fourth portion HP2 may be arranged between the third portions HP1 adjacent thereto in the direction normal (e.g., perpendicular) to the third direction DR3.

Each of the plurality of third portions HP1 and the plurality of fourth portions HP2 may have a shape extending in the third direction DR3 which is the thickness direction. In one or more embodiments, FIG. 6B illustrates that the hole injection layer HIL includes three third portions HP1 and four fourth portions HP2, but one or more embodiments of the present disclosure is not limited thereto.

The plurality of third portions HP1 including the second amine compound in the hole injection layer HIL may correspond to a path through which charges move. For example, in the light emitting element, a current may flow through the hole injection layer HIL in the third direction DR3 which is the thickness direction. The fourth portion HP2 including the second fluorine-containing compound in the hole injection layer HIL may exhibit insulating properties. Accordingly, a current flow in the hole injection layer HIL may be induced to be limited to the third portion HP1. The fourth portion HP2 is arranged between the third portions HP1 adjacent thereto in the direction normal (e.g., perpendicular) to the thickness direction, thereby preventing or reducing lateral leakage current from occurring between adjacent pixels.

In the light emitting element of one or more embodiments, the hole injection layer HIL may be formed to be doped with a p-dopant material for relatively high charge mobility. When the hole injection layer HIL is formed as a common layer, it may act as a path for the movement of charges, resulting in a lateral leakage current in which charges flow into one pixel during driving of another pixel through the hole injection layer HIL. According to the present disclosure, in the light emitting element including a plurality of light emitting stacks, in addition to including the amine compound and the fluorine-containing compound in the hole injection layer HIL doped with p-dopants, the hole transport auxiliary layer HTAL1 including a separate amine compound and fluorine-containing compound is arranged adjacent to the hole injection layer HIL, thereby preventing or reducing lateral leakage current from occurring.

According to the present disclosure, in addition to the hole injection layer HIL including the amine compound and the fluorine-containing compound, the functional layer formed to be in contact with the hole injection layer HIL is formed to include a separate amine compound and fluorine-containing compound, thereby preventing or reducing lateral leakage current from occurring.

In one or more embodiments, the second fluorine-containing compound may be a material containing fluorine. For example, the second fluorine-containing compounds may include at least one fluoropolymer, e.g., at least one of TEFLON (e.g., Teflon polymer or PTFE (polytetrafluoroethylene) polymer) or CYTOP (e.g., Cytop (cyclized transparent optical polymer).

In one or more embodiments, the hole injection layer HIL may be formed using a vacuum deposition method. The hole injection layer HIL may be formed by concurrently (e.g., simultaneously) depositing an organic material containing the second amine compound, and the second fluorine-containing compound. For example, an organic material containing a p-dopant and a second amine compound and a second fluorine-containing compound may be co-deposited on a substrate to be deposited to form the hole injection layer HIL. When the second fluorine-containing compound and the organic material containing the p-dopant and the second amine compound are co-deposited, the organic material and the second fluorine-containing compound may be phase-separated on the substrate to form a plurality of third portions HP1 and a plurality of fourth portions HP2.

In one or more embodiments, the water contact angle of the second fluorine-containing compound may be about 110° or more. When the water contact angle of the second fluorine-containing compound is about 110° or more, the organic material including the compound and the amine compound and the fluorine-containing compound may be possible to be alternately stacked in the vertical direction with respect to the substrate to be deposited. When the water contact angle of the second fluorine-containing compound is less than about 110°, it is difficult to arrange the organic material containing the amine compound and the fluorine-containing compound in the vertical direction, so that it may be difficult to provide a vertical current path in the film, and the leakage current blocking effect may be deteriorated.

In one or more embodiments, in order for the second fluorine-containing compound not to impair the hole transport properties of the second amine compound, the LUMO level of the second fluorine-containing compound may be about 5.0 eV or less. When the LUMO level of the second fluorine-containing compound is greater than about 5.0 eV, the hole transport properties of the second amine compound may be deteriorated.

In one or more embodiments, in the hole injection layer HIL, the mass ratio of the second amine compound and the second fluorine-containing compound may be about 3:7 to about 5:5. When the mass ratio of the second amine compound and the second fluorine-containing compound satisfies the herein-described range, the phase separation of the second amine compound and the second fluorine-containing compound in the horizontal direction may effectively occur in the hole injection layer HIL.

In one or more embodiments, the molecular weight of the second fluorine-containing compound may be about 300 g/mol to about 5,000 g/mol. When the molecular weight of the second fluorine-containing compound is less than about 300 g/mol, the compound may be pyrolyzed by a high temperature during the vacuum deposition process, thereby deteriorating the film durability. In some embodiments, if (e.g., when) the molecular weight of the second fluorine-containing compound is greater than about 5,000 g/mol, the vacuum deposition temperature may be increased due to the high molecular weight, and thus it may be unsuitable for film formation by co-deposition. When the molecular weight of the second fluorine-containing compound satisfies the herein-described range, it may be applied to a vacuum deposition process while maintaining the thermal stability of the material, thereby further improving the film durability.

In order not to impair the luminescence characteristics of the adjacent emission layer EML1, the first hole transport auxiliary layer HTAL1 may be arranged to be spaced and/or apart (e.g., spaced apart or separated) from the first emission layer EML1 by a set or predetermined distance. For example, the upper surface of the first hole transport auxiliary layer HTAL1 may not be in contact with the lower surface of the first emission layer EML1. In one or more embodiments, the first hole transport auxiliary layer HTAL1 may be arranged to be spaced and/or apart (e.g., spaced apart or separated) from the first emission layer EML 1 with the hole transport layer HTL interposed therebetween.

In one or more embodiments, the first hole transport auxiliary layer HTAL1 may be arranged to be spaced and/or apart (e.g., spaced apart or separated) from the first emission layer EML1 by a first distance d₁ with respect to the thickness direction. The first distance d₁ between the first hole transport auxiliary layer HTAL1 and the first emission layer EML1 may refer to an average distance from the upper surface of the first hole transport auxiliary layer HTAL1 to the lower surface of the first emission layer EML1. In one or more embodiments, the first distance d₁ may be about 10 nm or more. For example, the first distance d₁ may be about 10 nm to about 500 nm. When the first distance d₁ is less than about 10 nm, the luminescence characteristics of the first emission layer EML1 may be deteriorated by the first hole transport auxiliary layer HTAL1, and thus, the luminous efficiency and service life characteristics of the light emitting element ED may be deteriorated.

In the hole injection layer HIL, each of the third width W_{H1} of the third portion HP1 and the fourth width W_{H2} of the fourth portion HP2 may be determined by a difference in surface energy between the target substrate and the second fluorine-containing compound, a weight ratio of the second amine compound and the second fluorine-containing compound, and/or the like. The third width W_{H1} of the third portion HP1 may refer to a minimum width of the third portion HP1 measured in the direction normal (e.g., perpendicular) to the third direction DR3, and the fourth width W_{H2} of the fourth portion HP2 may refer to a minimum width of the fourth portion HP2 measured in the direction normal (e.g., perpendicular) to the third direction DR3. In one or more embodiments, the first width W_{A1} of the first portion AP1 and the third width W_{H1} of the third portion HP1 may be substantially the same, and the second width W_{A2} of the second portion AP2 and the fourth width W_{H2} of the fourth portion HP2 may be substantially the same. However, one or more embodiments of the present disclosure is not limited thereto.

The first portion AP1 of the first hole transport auxiliary layer HTAL1 and the third portion HP1 of the hole injection layer HIL may overlap each other on a plane. The second portion AP2 of the first hole transport auxiliary layer HTAL1 and the fourth portion HP2 of the hole injection layer HIL may overlap each other on a plane. In one or more embodiments, the first portion AP1 and the third portion HP1 may correspond to paths through which charges move. In the light emitting element of one or more embodiments, as the first portion AP1 of the first hole transport auxiliary layer HTAL1 including the first amine compound and the third portion HP1 of the hole injection layer HIL including the second amine compound overlap each other, stable vertical current characteristics may be exhibited. In some embodiments, in the light emitting element of one or more embodiments, as the second portion AP2 of the first hole transport auxiliary layer HTAL1 including the first fluorine-containing compound and the fourth portion HP2 of the hole injection layer HIL including the second fluorine-containing compound overlap each other, horizontal current flow may be effectively blocked.

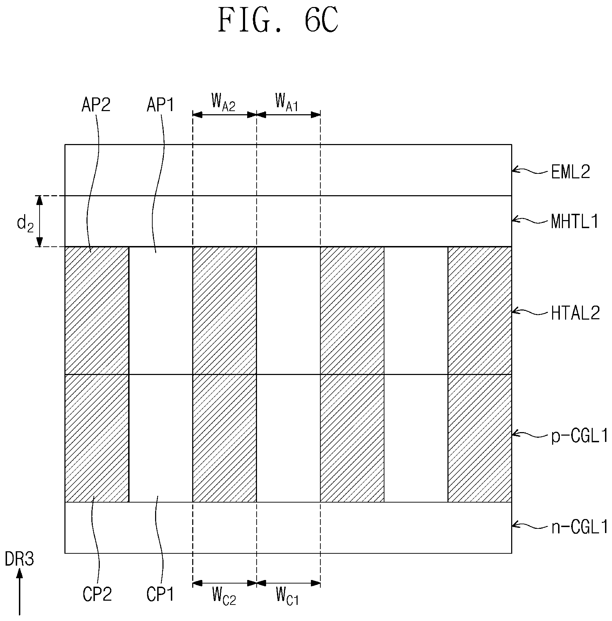

FIG. 6C is a cross-sectional view illustrating a partial configuration of a light emitting element of one or more embodiments. FIG. 6C illustrates only a partial configuration of the light emitting elements ED-a and ED-b illustrated in FIGS. 5B and 5C. FIG. 6C illustrates the first n-type (kind) charge generation layer n-CGL1, the first p-type (kind) charge generation layer p-CGL1, the second hole transport auxiliary layer HTAL2, the first middle hole transport layer MHTL1, and the second emission layer EML2 illustrated in FIGS. 5B and 5C, and the remaining layers are omitted. Hereinafter, in describing a light emitting element according to one or more embodiments of the present disclosure with reference to FIG. 6C, the same reference numerals will be given to the components described herein with reference to FIGS. 5A to 5D and 6A, and detailed descriptions thereof will not be provided.

Referring to FIG. 6C, the light emitting element of one or more embodiments may include the second hole transport auxiliary layer HTAL2 adjacent to the first p-type (kind) charge generation layer p-CGL1. The second hole transport auxiliary layer HTAL2 may be arranged in contact with the first p-type (kind) charge generation layer p-CGL1. In one or more embodiments, the second hole transport auxiliary layer HTAL2 may include a first amine compound and a first fluorine-containing compound, and the first p-type (kind) charge generation layer p-CGL1 may include a p-dopant, a second amine compound, and a second fluorine-containing compound.

The second amine compound and the second fluorine-containing compound may be composed to be phase-separated in the first p-type (kind) charge generation layer p-CGL1. In the first p-type (kind) charge generation layer p-CGL1, the second amine compound and the second fluorine-containing compound may be provided while being phase-separated from each other in the direction normal (e.g., perpendicular) to the third direction DR3.

The first p-type (kind) charge generation layer p-CGL1 may include a plurality of fifth portions CP1 including the p-dopant and the second amine compound, and a sixth portion CP2 including the second fluorine compound. In one or more embodiments, the plurality of fifth portions CP1 and the plurality of sixth portions CP2 may be alternately arranged in the direction normal (e.g., perpendicular) to the thickness direction. In the first p-type (kind) charge generation layer p-CGL1, the fifth portion CP1 may be arranged between the sixth portions CP2 adjacent thereto in the direction normal (e.g., perpendicular) to the third direction DR3.

Each of the plurality of fifth portions CP1 and the plurality of sixth portions CP2 may have a shape extending in the third direction DR3 which is the thickness direction. In one or more embodiments, FIG. 6C illustrates that the first p-type (kind) charge generation layer p-CGL1 includes three fifth portions CP1 and four sixth portions CP2, but one or more embodiments of the present disclosure is not limited thereto.

In the first p-type (kind) charge generation layer p-CGL1, the plurality of fifth portions CP1 including the second amine compound may correspond to a path through which charges move. For example, in the light emitting element, a current may flow in the third direction DR3, which is the thickness direction, through the first p-type (kind) charge generation layer p-CGL1. In the first p-type (kind) charge generation layer p-CGL1, the sixth portion CP2 including the second fluorine-containing compound may exhibit insulating properties. Accordingly, the current flow in the first p-type (kind) charge generation layer p-CGL1 may be induced to be limited to the fifth portion CP1. The sixth portion CP2 is arranged between the fifth portions CP1 adjacent thereto in the direction normal (e.g., perpendicular) to the thickness direction, thereby preventing or reducing the lateral leakage current from occurring between adjacent pixels.

In the light emitting element of one or more embodiments, the first p-type (kind) charge generation layer p-CGL1 may be formed to be doped with a p-dopant material for relatively high charge mobility. When the first p-type (kind) charge generation layer p-CGL1 is formed as a common layer, it may act as a path for the movement of charges, resulting in a lateral leakage current in which charges flow into one pixel during driving of another pixel through the first p-type (kind) charge generation layer p-CGL1. According to the present disclosure, in the light emitting element including the plurality of light emitting stacks, in addition to including the amine compound and the fluorine-containing compound in the first p-type (kind) charge generation layer p-CGL1 doped with p-dopants, the hole transport auxiliary layer HTAL2 including a separate amine compound and fluorine-containing compound is arranged adjacent to the first p-type (kind) charge generation layer p-CGL1, thereby preventing or reducing the lateral leakage current from occurring.

In one or more embodiments, the preceding description in FIG. 6B may be equally applied to the second amine compound and the second fluorine-containing compound included in the first p-type (kind) charge generation layer p-CGL1 of FIG. 6C.

In one or more embodiments, the first p-type (kind) charge generation layer p-CGL1 may be formed using a vacuum deposition method. The first p-type (kind) charge generation layer p-CGL1 may be formed by concurrently (e.g., simultaneously) depositing the organic material including the p-dopant and the second amine compound, and the second fluorine-containing compound. For example, the first p-type (kind) charge generation layer p-CGL1 may be formed by co-depositing the organic material including the p-dopant and the second amine compound, and the second fluorine-containing compound on a substrate to be deposited. When the second fluorine-containing compound and the organic material containing the p-dopant and the second amine compound are co-deposited, the organic material and the second fluorine-containing compound may be phase-separated on the substrate to form a plurality of fifth portions CP1 and a plurality of sixth portions CP2.

In order not to impair the luminescence characteristics of the adjacent emission layer EML2, the second hole transport auxiliary layer HTAL2 may be arranged to be spaced and/or apart (e.g., spaced apart or separated) from the second emission layer EML2 by a set or predetermined distance. For example, the upper surface of the second hole transport auxiliary layer HTAL2 may not be in contact with the lower surface of the second emission layer EML2. In one or more embodiments, the second hole transport auxiliary layer HTAL2 may be arranged to be spaced and/or apart (e.g., spaced apart or separated) from the second emission layer EML2 with the first middle hole transport layer MHTL1 interposed therebetween.

In one or more embodiments, the second hole transport auxiliary layer HTAL2 may be arranged to be spaced and/or apart (e.g., spaced apart or separated) from the second emission layer EML2 by a second distance d₂ with respect to the thickness direction. The second distance d₂ between the second hole transport auxiliary layer HTAL2 and the second emission layer EML2 may refer to an average distance from the upper surface of the second hole transport auxiliary layer HTAL2 to the lower surface of the second emission layer EML2. In one or more embodiments, the second distance d₂ may be about 10 nm or more. For example, the second distance d₂ may be about 10 nm to about 500 nm. When the second distance d₂ is less than about 10 nm, the luminescence characteristics of the second emission layer EML2 may be deteriorated by the second hole transport auxiliary layer HTAL2, and thus, the luminous efficiency and service life characteristics of the light emitting element ED may be deteriorated.

The first portion AP1 of the second hole transport auxiliary layer HTAL2 and the fifth portion CP1 of the first p-type (kind) charge generation layer p-CGL1 may overlap each other on a plane. The second portion AP2 of the second hole transport auxiliary layer HTAL2 and the sixth portion CP2 of the first p-type (kind) charge generation layer p-CGL1 may overlap each other on a plane. In one or more embodiments, the first portion AP1 and the fifth portion CP1 may correspond to paths through which charges move. In the light emitting element of one or more embodiments, as the first portion AP1 of the second hole transport auxiliary layer HTAL2 including the first amine compound and the fifth portion CP1 of the first p-type (kind) charge generation layer p-CGL1 including the second amine compound overlap each other, stable vertical current characteristics may be exhibited. In some embodiments, in the light emitting element of one or more embodiments, as the second portion AP2 of the second hole transport auxiliary layer HTAL2 including the first fluorine-containing compound and the sixth portion CP2 of the first p-type (kind) charge generation layer p-CGL1 including the second fluorine-containing compound overlap each other, horizontal current flow may be effectively blocked.

Adjacent light emitting elements ED-1, ED-2, and ED-3 (see FIG. 4) in the display panel DP (see FIG. 4) may operate independently. When common layers are present in the plurality of light emitting stacks, the lateral leakage current in which a leakage current flows from one light emitting element to an adjacent light emitting element in the horizontal direction may occur. The lateral leakage current may cause crosstalk that light of an adjacent pixel is emitted due to the lateral leakage current of an operating pixel, and such crosstalk may cause the deterioration of the display panel, poor image quality, and/or the like. In one or more embodiments, in order to implement a high-resolution display panel, a distance between pixels in the display panel may be reduced. However, the deterioration phenomenon due to the lateral leakage current through the common layer may be worsened as the distance between the pixels is reduced.

According to the present disclosure, in order to reduce the lateral leakage current and accompanying deterioration in the light emitting element, the lateral leakage current may be minimized or reduced regardless of an increase in resolution of the display panel by forming a layer doped with p-dopants and a functional layer in contact with the layer doped with p-dopants to each include the amine compound and the fluorine-containing compound, and thus, it is possible to implement a display panel having improved display quality and reliability. For example, one or more embodiments of the present disclosure aim to reduce lateral leakage current and the associated deterioration in light-emitting elements. This is achieved by forming a layer doped with p-dopants and a functional layer in contact with it, both containing an amine compound and a fluorine-containing compound. This approach helps minimize or reduce leakage current even with increased display resolution, resulting in a display panel with improved quality and reliability.

Terms such as "substantially," "about," and "approximately" are used as relative terms and not as terms of degree, and are intended to account for the inherent deviations in measured or calculated values that would be recognized by those of ordinary skill in the art. They may be inclusive of the stated value and an acceptable range of deviation as determined by one of ordinary skill in the art, considering the limitations and error associated with measurement of that quantity. For example, "about" may refer to one or more standard deviations, or ± 30%, 20%, 10%, 5% of the stated value.

Numerical ranges disclosed herein include and are intended to disclose all subsumed sub-ranges of the same numerical precision. For example, a range of "1.0 to 10.0" includes all subranges having a minimum value equal to or greater than 1.0 and a maximum value equal to or less than 10.0, such as, for example, 2.4 to 7.6.

Hereinafter, a result of evaluating characteristics of the light emitting element of one or more embodiments will be described with reference to Examples and Comparative Examples. In some embodiments, the Examples described in more detail are only illustrations to assist the understanding of the present disclosure, and the scope of the present disclosure is not limited thereto.

### EXAMPLES

### Manufacture of Light Emitting Elements

### Manufacture of Light Emitting Element of an Example

A light emitting element of an Example was manufactured as a tandem light emitting element by forming a first electrode on a glass substrate, sequentially forming a first light emitting stack on the first electrode, a charge generation layer, and a second light emitting stack, and then forming a second electrode and a capping layer. The tandem light emitting element of the Example was manufactured based on the structure of the light emitting element illustrated in FIG. 5B.

The first light emitting stack was formed to include a hole transport region, a first emission layer, and a middle electron transport region. The second light emitting stack was formed to include a middle hole transport region, a second emission layer, and an electron transport region. In the light emitting element of the Example, each of the first emission layer and the second emission layer respectively included in the first light emitting stack and the second light emitting stack was manufactured to have a single-layered structure.

The charge generation layer including an n-type (kind) charge generation layer and a p-type (kind) charge generation layer was provided between the stacked light emitting stacks. 2,9-Dimethyl-4,7-diphenyl-1,10-phenanthroline (BCP) was doped with Li to form the n-type (kind) charge generation layer. In the n-type (kind) charge generation layer, BCP and Li were provided in a weight ratio of about 95:5. The n-type (kind) charge generation layer was formed to have a thickness of about 75 Angstroms (Å). On the n-type (kind) charge generation layer, a p-type (kind) charge generation layer was formed of an organic material doped with F4-TCNQ by 1% to 5% in a mixture in which α-NPD and CYTOP (e.g., Cytop polymer) were mixed in a ratio (e.g., amount) of about 3:7 to about 5:5. The p-type (kind) charge generation layer was formed to have a thickness of about 100 Å.

A hole transport region was formed by depositing, on the first electrode, an organic material doped with F4-TCNQ by 1% to 5% in the mixture in which α-NPD and CYTOP (e.g., Cytop polymer) were mixed in a ratio (e.g., amount) of about 3:7 to about 5:5 to form a hole injection layer having a thickness of about 50 Å to about 100 Å, depositing, on the hole injection layer, the mixture in which α-NPD and CYTOP (e.g., Cytop polymer) were mixed in a ratio (e.g., amount) of about 3:7 to about 5:5 to form a first hole transport auxiliary layer having a thickness of about 100 Å, and depositing α-NPD on the first hole transport auxiliary layer to form a hole transport layer having a thickness of about 100 Å.

A middle hole transport region was manufactured by depositing, on the p-type (kind) charge generation layer, the mixture in which α-NPD and CYTOP (e.g., Cytop polymer) were mixed in a ratio (e.g., amount) of about 3:7 to about 5:5 to form a second hole transport auxiliary layer having a thickness of about 100 Å, and depositing α-NPD on the second hole transport auxiliary layer to form a first middle hole transport layer having a thickness of about 100 Å.

A middle electron transport region was formed to include a 50-Å thick first middle electron transport layer of 2,4,6-tris(biphenyl-3-yl)-1,3,5-triazine (T2T).

An electron transport region was formed to include a 50-Å thick electron transport layer of 2,4,6-tris(biphenyl-3-yl)-1,3,5-triazine (T2T) and a 100-Å thick electron injection layer in which 2,4,6-tris(3-(pyrimidin-5-yl)phenyl)-1,3,5-triazine (TPM-TAZ) was co-deposited by addition of Liq. In the electron injection layer, TPM-TAZ and Liq were included in a weight ratio of about 5:5.

A first electrode was formed to have a structure of ITO/Ag/ITO, and a second electrode was formed from AgMg. Each layer of the light emitting structure was formed by a deposition method in a vacuum condition. A capping layer having a thickness of about 700 Å was formed on the second electrode by using N4,N4'-dipheny-N4,N4'-bis(9-phenyl-9H-carbazol-3-yl)biphenyl-4,4'-diamine.

### Manufacture of Light Emitting Element of a Comparative Example

A light emitting element of a Comparative Example was manufactured in substantially the same manner as the light emitting element of the Example, except that the step (e.g., act or task) of forming the first hole transport auxiliary layer and the second hole transport auxiliary layer was omitted. The light emitting element of the Comparative Example corresponds to a light emitting element having the same configuration as that of the Example, except that the first hole transport auxiliary layer and the second hole transport auxiliary layer are not included.

### Evaluation of Light Emitting Elements

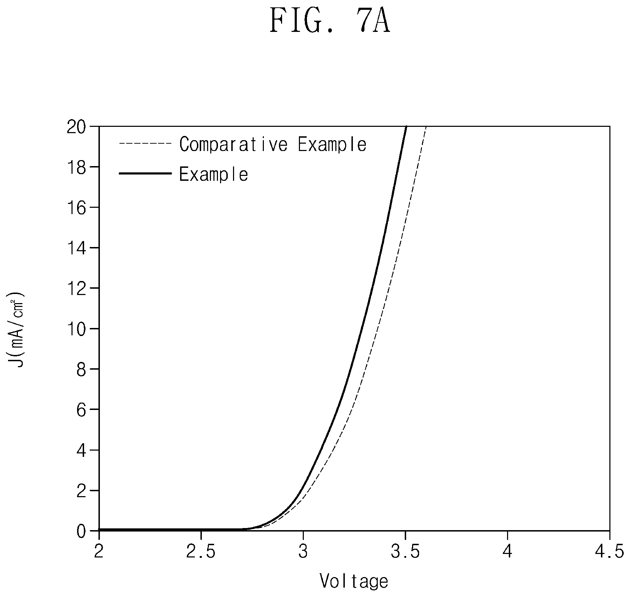

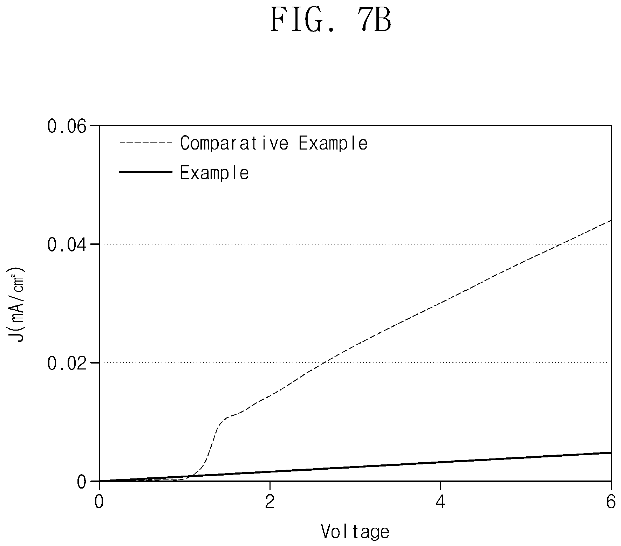

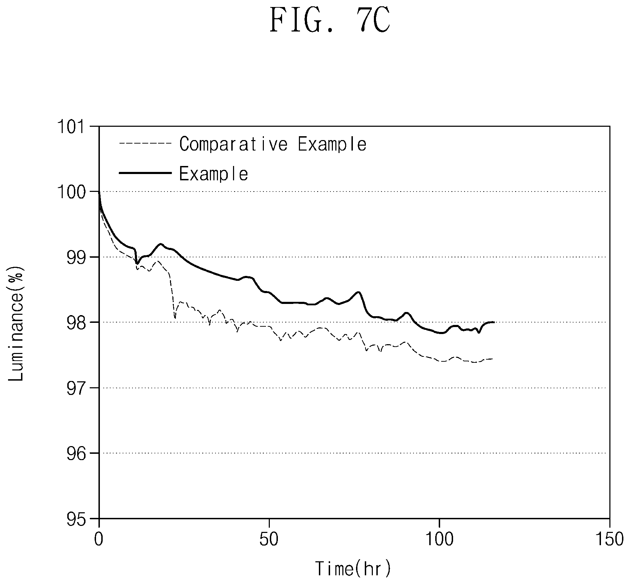

FIGS. 7A and 7B are graphs showing a current density depending on voltage in the light emitting elements of the Example and the Comparative Example. In the light emitting elements, the measurement of voltage application and current was performed by using Keithley equipment. In some embodiments, the measurement of brightness was performed by using SR3 spectrometer. FIG. 7C is a graph showing changes in brightness over time in the light emitting elements of the Example and the Comparative Example. In FIG. 7A, the current density depending on a driving voltage was measured by applying a vertical current to the light emitting element and the results are shown. In FIG. 7B, the current density depending on a driving voltage was measured by applying a horizontal current to the light emitting element and the results are shown. In the present specification, the "vertical current" method refers to a method of applying a current in the vertical direction with respect to a thin film surface, and the "horizontal current" method refers to a method of applying a current in the horizontal direction with respect to a thin film surface. In the graphs of FIGS. 7A and 7B, the unit of voltage is [V] and the unit of current density is [milliampere per square centimeter (mA/cm²)].

Referring to FIG. 7A, it may be seen that the light emitting element of the Example exhibits a current density similar to that of the Comparative Example. The fact that the current density of the light emitting element of the Example is obtained similarly to the current density of the light emitting element of the Comparative Example suggests that the light emitting element of the Example may maintain stability similar to that of the comparable light emitting element. Referring to FIG. 7B, it may be seen that the current density of the light emitting element of the Comparative Example rapidly increases at a point at which the driving voltage is about 1.2 V, but the current density of the light emitting element of the Example does not change significantly even if (e.g., when) the driving voltage increases. Accordingly, it may be seen that the light emitting element of the Example effectively blocks the horizontal leakage current compared to the light emitting element of the Comparative Example. It may be seen from FIGS. 7A and 7B that in the case of the light emitting element of the Example, the horizontal current flow may be effectively blocked and stable vertical current characteristics may be exhibited.

In some embodiments, referring to FIG. 7C, in general, it may be seen that the deterioration speed of the light emitting element is accelerated as the driving time increases, and thus the brightness characteristics gradually decrease. For example, it may be seen that the brightness gradually decreases from the initial brightness as the driving time increases because the deterioration of the light emitting element progresses according to the driving time. As may be seen from FIG. 7C, it may be seen that the brightness decrease rate of the light emitting element of the Example is improved compared to that of the light emitting element of the Comparative Example. Accordingly, it may be expected that the display device including the light emitting element of Example may display a high-brightness image for a long period of time compared to the light emitting element of Comparative Example.

According to one or more embodiments of the present disclosure, the hole transport material and the fluorine-containing compound are included in the hole injection layer or the p-charge generation layer doped with the p-dopant and the functional layer adjacent thereto, thereby minimizing or reducing leakage current between adjacent pixels. Accordingly, the display efficiency and display service life of the display panel including the light emitting element of the present disclosure may be improved.

In other words, the provided figures and graphs illustrate the performance of light-emitting elements in terms of current density and brightness over time. FIGS. 7A and 7B show the current density as a function of voltage for both vertical and horizontal currents. The measurements were conducted using Keithley equipment for voltage and current, and an SR3 spectrometer for brightness. The results indicate that the light-emitting element of the Example maintains a stable current density similar to the Comparative Example when a vertical current is applied. However, when a horizontal current is applied, the Example shows significantly less increase in current density at higher voltages, effectively blocking horizontal leakage current.

FIG. 7C demonstrates the changes in brightness over time, showing that the light-emitting element of the Example has a slower rate of brightness decrease compared to the Comparative Example. This suggests that the Example can maintain high brightness for a longer period, enhancing the display device's performance. The inclusion of hole transport material and fluorine-containing compounds in specific layers helps minimize leakage current between adjacent pixels, thereby improving the display efficiency and lifespan of the display panel.

The electronic device, display panel, a device of manufacturing thereof, and/or any other relevant devices or components according to embodiments of the present disclosure described herein may be implemented utilizing any suitable hardware, firmware (e.g., an application-specific integrated circuit), software, or a combination of software, firmware, and hardware. For example, the one or more suitable components of the electronic device and/or display panel may be formed on one integrated circuit (IC) chip or on separate IC chips. Further, the one or more suitable components of the electronic device, and/or display panel may be implemented on a flexible printed circuit film, a tape carrier package (TCP), a printed circuit board (PCB), or formed on one substrate. Further, the one or more suitable components of the electronic device, and/or display panel may be a process or thread, running on one or more processors, in one or more computing devices, executing computer program instructions and interacting with other system components for performing the one or more suitable functionalities described herein. The computer program instructions are stored in a memory which may be implemented in a computing device using a standard memory device, such as, for example, a random access memory (RAM). The computer program instructions may also be stored in other non-transitory computer readable media such as, for example, a CD-ROM, flash drive, or the like. Also, a person of skill in the art should recognize that the functionality of one or more suitable computing devices may be combined or integrated into a single computing device, or the functionality of a particular computing device may be distributed across one or more other computing devices without departing from the scope of the embodiments of the present disclosure.

In the context of the present application and unless otherwise defined, the terms "use," "using," and "used" may be considered synonymous with the terms "utilize," "utilizing," and "utilized," respectively.

A person of ordinary skill in the art, in view of the present disclosure in its entirety, would appreciate that each suitable feature of the one or more suitable embodiments of the present disclosure may be combined or combined with each other, partially or entirely, and may be technically interlocked and operated in one or more suitable ways, and each embodiment may be implemented independently of each other or in conjunction with each other in any suitable manner unless otherwise stated or implied.

Although the present disclosure has been described with reference to embodiments of the present disclosure, it will be understood that the present disclosure should not be limited to these embodiments but one or more suitable changes and modifications can be made by those skilled in the art without departing from the scope of the present disclosure. Accordingly, the technical scope of the present disclosure is not intended to be limited to the contents set forth in the detailed description of the specification, but is intended to be defined by the appended claims and equivalents thereof.

## Claims

1. A light emitting element comprising:
a first electrode;
a hole injection layer on the first electrode;
a first emission layer on the hole injection layer and configured to emit light of a first wavelength;
a first n-type charge generation layer on the first emission layer;
a first p-type charge generation layer on the first n-type charge generation layer;
a second emission layer on the first p-type charge generation layer and configured to emit light of a second wavelength, the second wavelength being different from the first wavelength;
an electron transport region on the second emission layer;
a second electrode on the electron transport region; and
a hole transport auxiliary layer adjacent to at least one adjacent layer selected from among the hole injection layer and the first p-type charge generation layer, and comprising a first amine compound and a first fluorine-containing compound,
wherein the at least one adjacent layer comprises a p-dopant, a second amine compound, and a second fluorine-containing compound.

2. The light emitting element of claim 1, wherein a weight ratio of the first amine compound to the first fluorine-containing compound is about 3:7 to about 5:5 in the hole transport auxiliary layer, and
a weight ratio of the second amine compound to the second fluorine-containing compound is about 3:7 to about 5:5 in the at least one adjacent layer.

3. The light emitting element of claim 1 or claim 2, wherein the first fluorine-containing compound and the second fluorine-containing compound each independently comprise at least one of **TEFLON** or CYTOP.

4. The light emitting element of any one of claims 1 to 3, wherein a water contact angle of each of the first fluorine-containing compound and the second fluorine-containing compound is independently at least about 110°.

5. The light emitting element of any one of claims 1 to 4, wherein a lowest unoccupied molecular orbital (LUMO) level of each of the first fluorine-containing compound and the second fluorine-containing compound is independently at most about 5.0 electron volt (eV).

6. The light emitting element of any one of claims 1 to 5, wherein the hole transport auxiliary layer comprises:
a plurality of first portions comprising the first amine compound; and
a plurality of second portions comprising the first fluorine-containing compound, and
the plurality of first portions and the plurality of second portions are arranged alternately in a direction perpendicular to a thickness direction.

7. The light emitting element of any one of claims 1 to 6, further comprising a hole transport layer on the hole injection layer,
wherein the hole transport auxiliary layer is between the hole injection layer and the hole transport layer.

8. The light emitting element of claim 7, wherein:
(i) the hole transport auxiliary layer is spaced from the first emission layer by a first distance with respect to a thickness direction, and
the first distance is at least about 10 nanometers (nm); and/or
(ii) the hole transport auxiliary layer is directly on the hole injection layer, and the hole transport layer is directly on the hole transport auxiliary layer.

9. The light emitting element of any one of claims 1 to 8, wherein the hole transport auxiliary layer is between the first p-type charge generation layer and the second emission layer.

10. The light emitting element of claim 9, wherein the hole transport auxiliary layer is spaced from the second emission layer by a second distance with respect to a thickness direction, and
the second distance is at least about 10 nm.

11. The light emitting element of claim 9 or claim 10, wherein:
(i) the hole transport auxiliary layer is directly on the first p-type charge generation layer; and//or
(ii) the light emitting element further comprises a middle hole transport layer between the hole transport auxiliary layer and the second emission layer and comprising a hole transporting material.

12. The light emitting element of any one of claims 1 to 11, further comprising a middle electron transport layer between the first emission layer and the first n-type charge generation layer.

13. The light emitting element of any one of claims 1 to 12, further comprising:
(i) a second n-type charge generation layer on the second emission layer;
a second p-type charge generation layer on the second n-type charge generation layer; and
a third emission layer on the second p-type charge generation layer and configured to emit light of a third wavelength, the third wavelength being different from the first wavelength and the second wavelength; and/or
(ii) a capping layer on the second electrode,
wherein the capping layer has a refractive index of at least 1.6.

14. An electronic device comprising:
a base layer comprising a non-display region and a display region comprising a first light emitting region, a second light emitting region, and a non-light emitting region; and
a display element layer on the base layer and comprising a first light emitting element overlapping the first light emitting region and a second light emitting element overlapping the second light emitting region,
wherein each of the first light emitting element and the second light emitting element comprises:
a first electrode;
a hole injection layer on the first electrode;
a first emission layer on the hole injection layer and configured to emit light of a first wavelength;
a first n-type charge generation layer on the first emission layer;
a first p-type charge generation layer on the first n-type charge generation layer;
a second emission layer on the first p-type charge generation layer and configured to emit light of a second wavelength, the second wavelength being different from the first wavelength;
an electron transport region on the second emission layer;
a second electrode on the electron transport region; and
a hole transport auxiliary layer adjacent to at least one adjacent layer selected from among the hole injection layer and the first p-type charge generation layer, and comprising a first amine compound and a first fluorine-containing compound,
wherein the at least one adjacent layer comprises a p-dopant, a second amine compound, and a second fluorine-containing compound.

15. The display panel of claim 14, wherein:
(i) the display panel further comprises:
an encapsulation layer on the display element layer; and
a plurality of color filters on the encapsulation layer and in each of the first light emitting region and the second light emitting region; and/or
(ii) the electronic device is a smartphone, a television, a monitor, a tablet, an electric vehicle, a mobile phone, a tablet personal computer (PC), a mobile communication terminal, an electronic notebook, an electronic book, a portable multimedia player (PMP), a navigation device, an ultra-mobile PC (UMPC), a laptop computer, a billboard, an Internet of Things (IoT) device, a smartwatch, a watch phone, or a head-mounted display (HMD).
